**Europäisches Patentamt**

**European Patent Office**

**Office européen des brevets**

(19)

(11) **EP 1 294 102 A1**

(12) **EUROPEAN PATENT APPLICATION**
published in accordance with Art. 158(3) EPC

(43) Date of publication:
**19.03.2003 Bulletin 2003/12**

(51) Int Cl.⁷: **H03M 13/23**

(21) Application number: **01934487.8**

(86) International application number:
**PCT/JP01/04642**

(22) Date of filing: **01.06.2001**

(87) International publication number:
**WO 01/097386 (20.12.2001 Gazette 2001/51)**

(84) Designated Contracting States:
**AT BE CH CY DE DK ES FI FR GB GR IE IT LI LU MC NL PT SE TR**

(30) Priority: **12.06.2000  JP  2000176150**

(71) Applicant: **MITSUBISHI DENKI KABUSHIKI KAISHA**
**Tokyo 100-8310 (JP)**

(72) Inventors:
• **MATSUMOTO, Wataru, c/o Mitsubishi Denki K K**
  **Chiyoda-ku, Tokyo 100-8310 (JP)**
• **NARIKAWA, Masafumi, c/o Mitsubishi Denki K K**
  **Chiyoda-ku, Tokyo 100-8310 (JP)**

(74) Representative: **Pfenning, Meinig & Partner**
**Mozartstrasse 17**
**80336 München (DE)**

(54) **COMMUNICATION APPARATUS AND COMMUNICATION METHOD**

(57)    The communication apparatus comprises a turbo encoder. This turbo encoder includes a first recursive systematic convolutional encoder which convolutionally encodes two information bit sequences to output first redundant data, and a second recursive systematic convolutional encoder which convolutionally encodes the information bit sequences subjected to an interleave process to output second redundant data. The first and second recursive systematic convolutional encoders are encoders which search all connection patterns constituting the encoders and which satisfy optimum conditions that an interval between two bits '1' of a self-terminated pattern is maximum in a specific block length and that a total weight in the pattern having the maximum interval is maximum in the specific block length.

# FIG.8

## EP 1 294 102 A1

**Description**

TECHNICAL FIELD

The present invention relates to a method of and apparatus for communications which employs a multi-carrier modulation/demodulation scheme. Particularly, this invention relates to a method of and apparatus for communications which make it possible to realize data communication using conventional communication lines by a DMT (Discrete Multi Tone) modulation/demodulation scheme, an OFDM (Orthogonal Frequency Division Multiplex) modulation/demodulation scheme, or the like. However, the present invention can be applied to not only a communication apparatus which performs data communication by the DMT modulation/demodulation scheme, but also all communication apparatuses which perform cable communication and wireless communication by a multi-carrier modulation/demodulation scheme and a single-carrier modulation/demodulation scheme through conventional communication lines.

BACKGROUND ART

A conventional communication apparatus will be described below. For example, in a wide-band CDMA (W-CDMA: Code Division Multiple access) using an SS (Spread Spectrum) scheme, a turbo code is proposed as an error correction code the performance of which is considerably higher than that of a convolutional code . This turbo code encodes a sequence obtained by interleaving an information bit sequence in parallel to a known encoding sequence. It is said that the turbo code achieves characteristics which are close to the Shannon limit. The turbo code is one of error correction codes which are most remarkable codes at the present. In the W-CDMA, transmission characteristics in audio transmission or data transmission are largely dependent on the performance of the error correction code. For this reason, the transmission characteristics can be considerably improved by applying the turbo code.

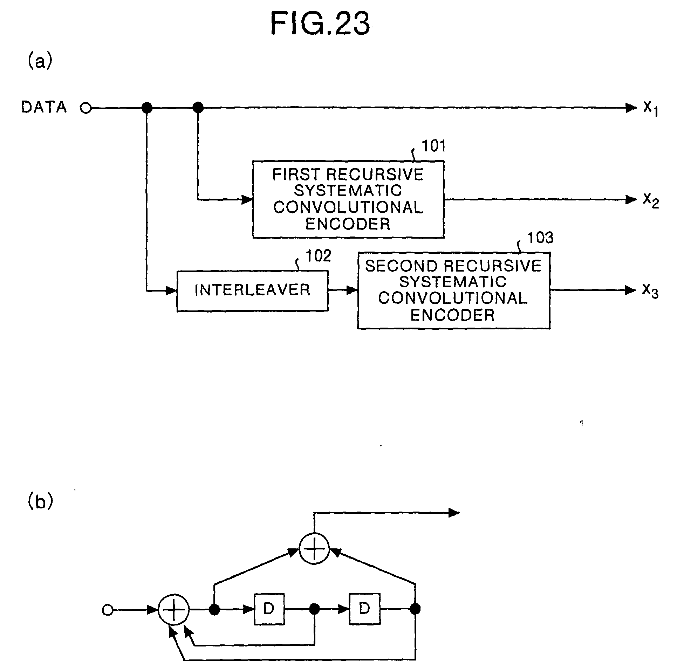

The operations of the transmission system and the reception system of a conventional communication apparatus using the turbo code will be described below. Fig. 23 is a diagram showing the configuration of a turbo encoder used in the transmission system. In Fig. 23(a), reference numeral 101 denotes a first recursive systematic convolutional encoder for convolutionally encoding an information bit sequence to output a redundant bit, reference numeral 102 denotes an interleaver, and reference numeral 103 denotes a second recursive systematic convolutional encoder for convolutionally encoding the information bit sequence rearranged by the interleaver 102 to output redundant bits. Fig. 23(b) is a diagram showing the internal configuration of the first recursive systematic convolutional encoder 101 and the second recursive systematic convolutional encoder 103. The two recursive systematic convolutional encoders are encoders for outputting only redundant bits. In the interleaver 102 used in the turbo encoder, a process of rearranging information bit sequences at random is performed.

In the turbo encoder constituted as described above, an information bit sequence: $x_1$, a redundant bit sequence: $x_2$ obtained by encoding the information bit sequence: $x_1$ by the process of the first recursive systematic convolutional encoder 101, and a redundant bit sequence: $x_3$ obtained by encoding the information bit sequence subjected to an interleave process by the process of the second recursive systematic convolutional encoder 103.

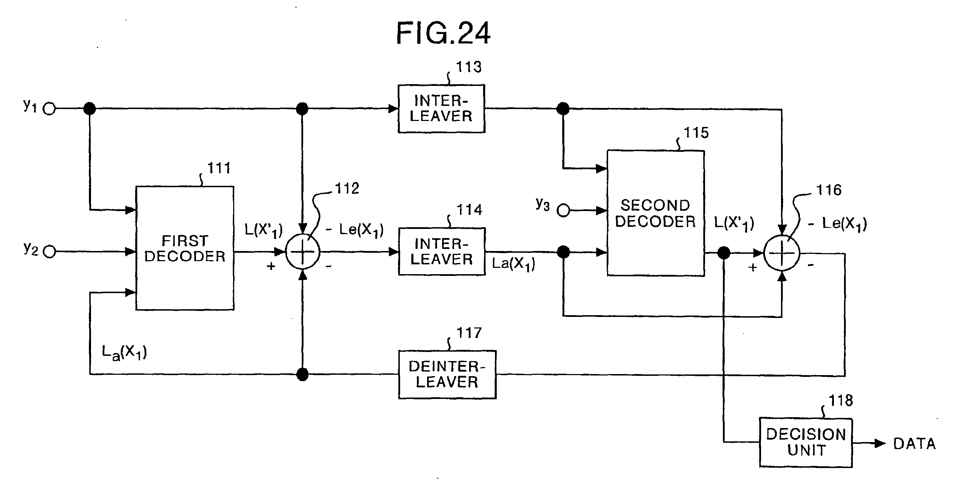

Fig. 24 is a diagram showing the configuration of a turbo decoder used in the reception system. In Fig. 24, reference numeral 111 denotes a first decoder for calculating a logarithmic likelihood ratio from a reception signal: $y_1$ and a reception signal: $y_2$, reference numerals 112 and 116 denote adders, reference numerals 113 and 114 denote interleavers, reference numeral 115 denotes a second decoder for calculating a logarithmic likelihood ratio from the reception signal: $y_1$ and a reception signal $y_3$, reference numeral 117 denotes a deinterleaver, and reference numeral 118 denotes a decision unit for deciding an output from the second decoder 115 to output an estimation value of an original information bit sequence. The reception signals $y_1$, $y_2$, and $y_3$ are signals which give the influences of noise or fading of transmission paths to the information bit sequence $x_1$ and the redundant bit sequences $x_2$ and $x_3$.

In this turbo decoder, the first decoder 111 calculates logarithmic likelihood ratio: $L(x_{1k}')$ of a estimated information bit: $x_{1k}'$ estimated from a reception signal: $y_{1k}$ and a reception signal: $y_{2k}$ (k represents time) . In this case, a probability that the information bit: $x_{1k}$ to a probability that an information bit: $x_{1k}$ is 0 is 1 is calculated. Illustrated symbol $Le(x_{1k})$ denotes external information, and symbol $La(x_{1k})$ denotes prior information which is previous external information.

In the adder 112, external information to the second decoder 115 is calculated from the logarithmic likelihood ratio which is the calculation result. In the first decoding, since prior information is not calculated, $La(x_{1k}) = 0$ is satisfied.

In the interleavers 113 and 114, in order to adjust the times of the reception signal: $y_{1k}$ and the external information: $Le(x_{1k})$ to the time of the reception signal $y_3$, signals are rearranged. Thereafter, in the second decoder 115, as in the first decoder 111, the logarithmic likelihood ratio: $L(x_{1k}')$ is calculated on the basis of the reception signal: $y_1$, the reception signal $y_3$, and the external information: $Le(x_{1k})$ which is calculated in advance. In the adder 116, the external information: $Le(x_{1k})$ is calculated. At this time, the pieces of external information which are rearranged by the deinterleaver 117 are fed back to the first decoder 111 as the prior information $La(x_{1k})$.

Finally, in this turbo decoder, the above-mentioned processes are repeated a predetermined number of times to calculate a logarithmic likelihood ratio having a high precision. The decision unit 118 makes a decision on the basis of the logarithmic likelihood ratio, and estimates the original information bit sequence. More specifically, forexample, when the logarithmic likelihood ratio satisfies "L($x_{1k}$') > 0", the estimation information bit: $x_{1k}$' is decided as 1. When "L($x_{1k}$') ≤ 0", the estimation information bit: $x_{1k}$' is decided as 0.

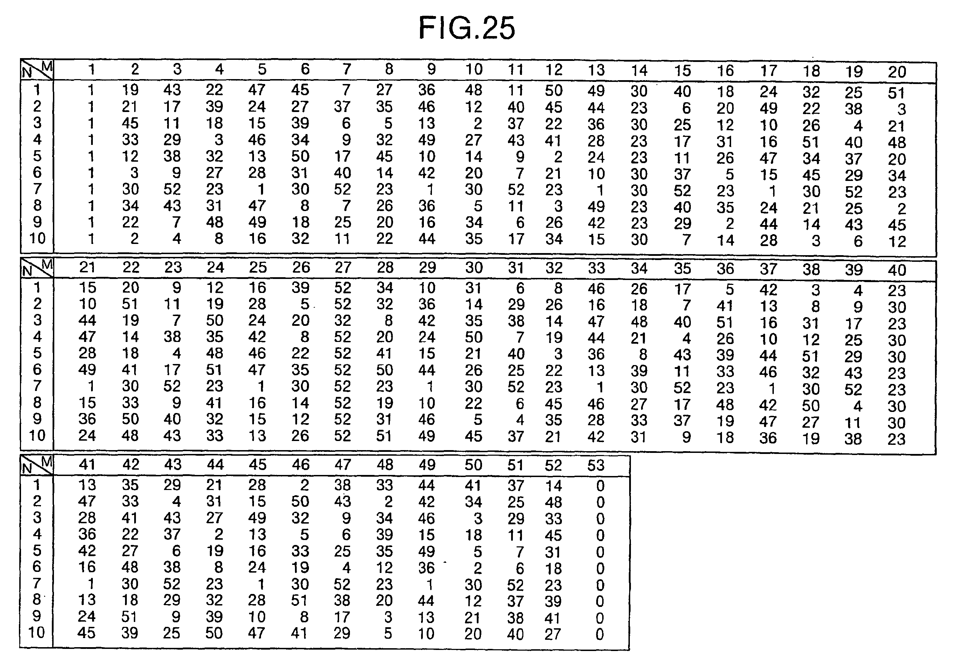

Figs. 25, 26, and 27 are tables showing processes of the interleaver 102 used in the turbo encoder. In this case, a process of rearranging information bit sequences at random by the interleaver 102 will be described below.

For example, in the W-CDMA, as an interleaver, a complex interleaver (to be referred to as a PIL hereinafter) is generally used. The PIL has the following three characteristic features.

1) Rows and columns in an N (ordinate: natural number) × M (abscissa: natural number) buffer are rearranged.
2) Pseudo random pattern using prime patterns is used in bit rearrangement in the rows.
3) A critical pattern is avoided by rearranging the rows.

The operation of the PIL which is a conventional interleaver will be described below. For example, when an interleaver length: $L_{turbo}$ = 512 bit, N = 10, M = P = 53 ($L_{turbo}$/N ≤ P + 1), and a primitive root: $g_0$ = 2 are satisfied, mapping patterns: c(i) are formed as indicated by the following Equation (1).

$$c(i) = (g_0 \times c\,(i\text{-}1))\ \text{mod} P \tag{1}$$

where i = 1, 2, ..., (P-2), and c(0) = 1.

According to the Equation (1), the mapping patterns: C(i) are given by {1, 2, 4, 8, 16, 32, 11, 22, 44, 35, 17, 34, 15, 30, 7, 14, 28, 3, 6, 12, 24, 48, 43, 33, 13, 26, 52, 51, 49, 45, 37, 21, 42, 31, 9, 18, 36, 19, 38, 23, 46, 39, 25, 50, 47, 41, 29, 5, 10, 20, 40, 27}.

In the PIL, the mapping patterns: C(i) are skipped every skipping pattern: $p_{PIP(j)}$ to rearrange bits, and mapping patterns: $C_j$(i) each having j rows are generated. In this case, in order to obtain {$p_{PIP(j)}$}, {$q_j$(j = 0 to N-1)} is determined under the conditions given by the following Equations (2), (3), and (4).

$$q_0 = 1 \tag{2}$$

$$\text{g.c.d}\{q_j,\ P\text{-}1\} = 1\ (\text{g.c.d is the greatest common}$$

$$\text{measure}) \tag{3}$$

$$q_j > 6,\ q_j > q_{j\text{-}1}\ (j = 1\ \text{to}\ N\text{ - }1) \tag{4}$$

Therefore, {$q_j$} is {1, 7, 11, 13, 17, 19, 23, 29, 31, 37}, and {$p_{PIP(j)}$} is {37, 31, 29, 23, 19, 17, 13, 11, 7, 1} (PIP = N-1 to 0).

Fig. 25 shows results obtained by skipping the mapping patterns: C(i) on the basis of the skipping patterns: $p_{PIP(j)}$, i.e., results obtained by rearranging the rows by using the skipping patterns.

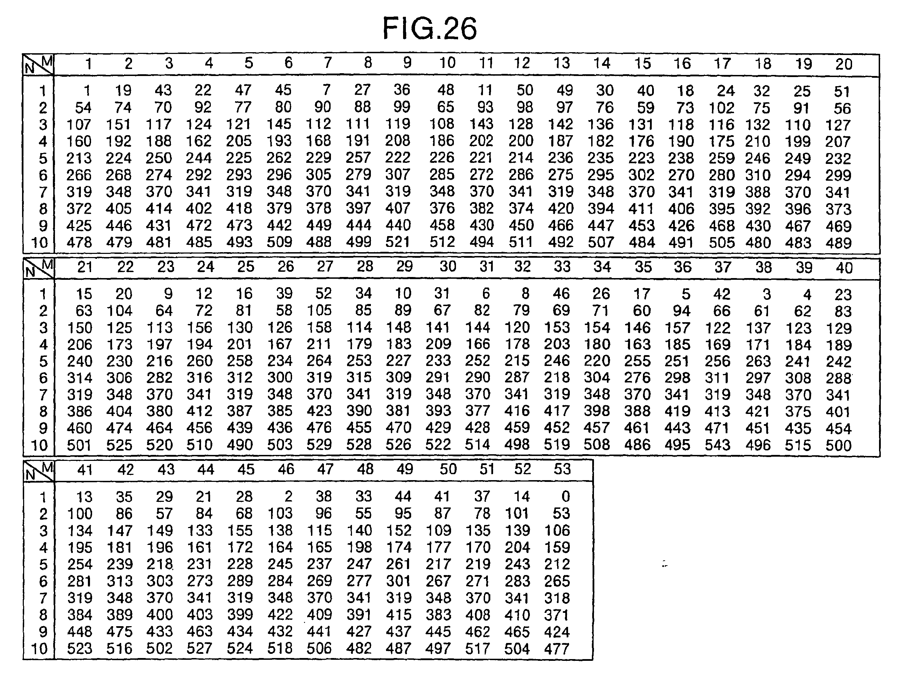

Fig. 26 shows data arrangements obtained when data having an interleaver length: $L_{turbo}$ = 512 bits are mapped on the rearranged mapping patterns. In this case, data {0 to 52} are mapped on the first row; {53 to 105} are mapped on the second row; data {106 to 158} are mapped on the third row; data {159 to 211} are mapped on the fourth row; {212 to 264} are mapped on the fifth row; data {265 to 317} are mapped on the sixth row; data {318 to 370} are mapped on the seventh row; data {371 to 423} are mapped on the eighth row; {424 to 476} are mapped on the ninth row; and data {477 to 529} are mapped on the tenth row.

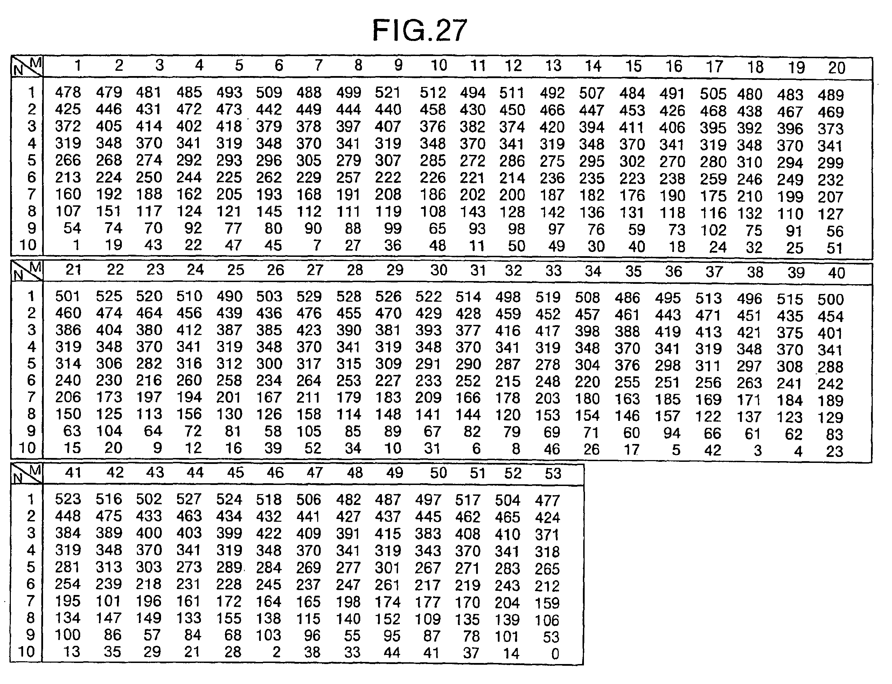

Finally, Fig. 27 shows a final rearrangement pattern. In this case, according to a predetermined rule, the rows are rearranged as shown in the data arrangements in Fig. 27 to generate a final rearrangement pattern (in this case, the orders of the respective rows are reversed). In the PIL, the generated rearrangement pattern is read in units of columns, i.e., is vertically read.

In this manner, when the PIL is used as an interleave, in interleave lengths (for example, $L_{turbo}$ = 257 to 8192 bits) in a wide range, turbo codes for generating code words serving as preferable weight distributions can be provided.

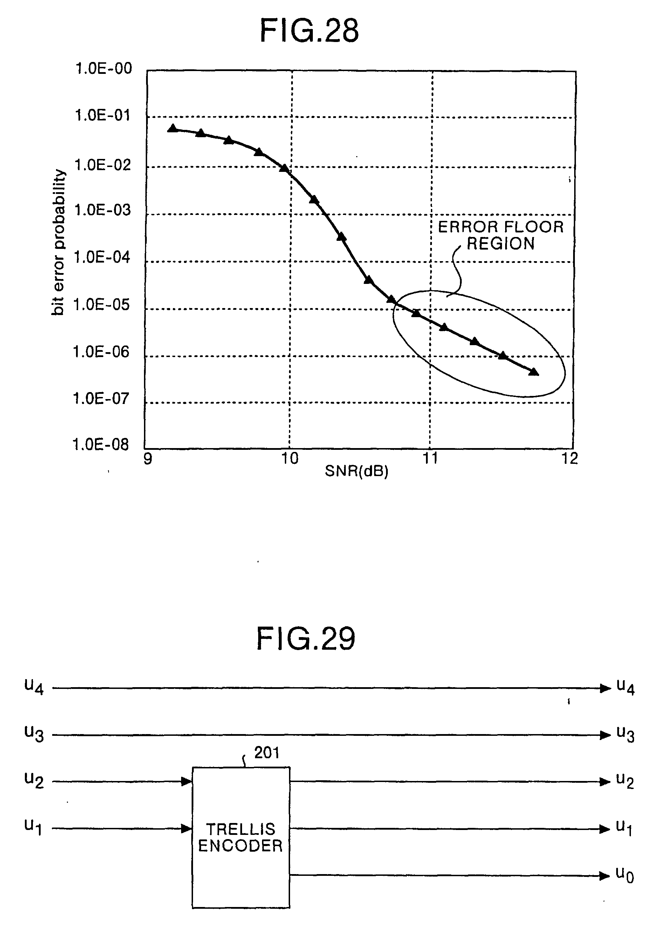

Fig. 28 is a graph showing BER (bit error rate) characteristics obtained when a conventional turbo encoder and a conventional turbo decoder including the PIL's. As shown in Fig. 28, as an SNR increases, the BER characteristics are improved.

In this manner, in the conventional communication apparatus, when a turbo code is applied as an error correction code, even though an inter-signal distance decreases depending on multi-valuing of the modulation scheme, transmission characteristics in audio transmission and data transmission can be considerably improved. As a result, characteristics which are better than those of a known convolutional code can be obtained.

In the conventional communication apparatus, turbo encoding is performed to all input information sequences (when there are a plurality of information bit sequences, all the information bit sequences), all the encoded signals are turbo-decoded on the reception side. Thereafter, soft decision is performed. More specifically, for example, a decision is performed to all 4-bit data (0000 to 1111: 4-bit constellations) in 16 QAM, and a decision is performed to all 8-bit data in 256 QAM.

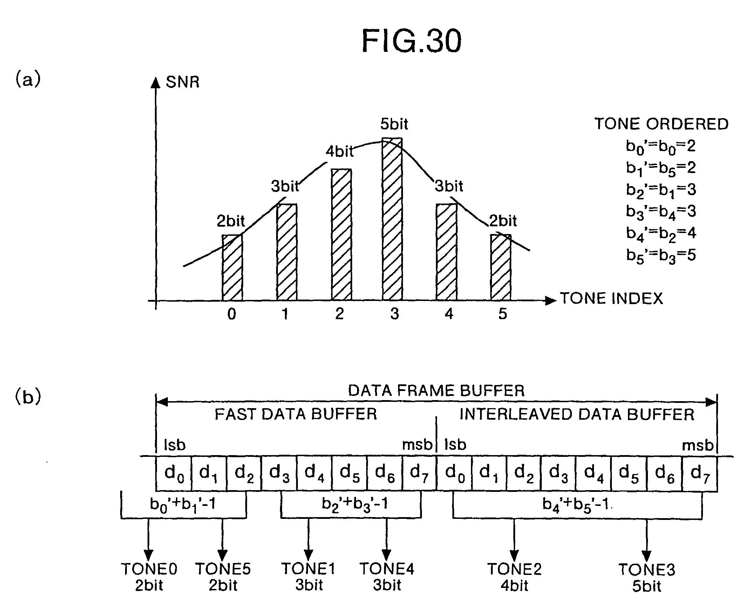

In a conventional communication apparatus which performs data communication by using a DMT modulation/demodulation scheme, turbo codes are not used. For this reason, the operation of a conventional communication apparatus using trellis codes will be briefly described below. Fig. 29 is a diagram showing the configuration of a trellis encoder used in the conventional communication apparatus. In Fig. 29, reference numeral 201 denotes a known trellis encoder. For example, in the trellis encoder 201, two information bits and one redundant bit are output with respect to an input of 2 information bits.

For example, when data communication by the DMT modulation/demodulation scheme is performed by using a known transmission path such as a telephone line, on the transmission side, a tone ordering process, i.e., a process of assigning transmission data each having bits the number of which can be transmitted to a plurality of tones (multi-carrier) in a preset frequency band is performed on the basis of an S/N (signal-to-noise ratio) ratio of the transmission path (this transmission determines a transmission rate).

More specifically, for example, as shown in Fig. 30 (a), transmission data each having bits the number of which is dependent on an S/N ratio are assigned to tone 0 to tone 5 of respective frequencies. In this case, transmission data of two bits are as signed to tone 0 and tone 5, transmission data of three bits are assigned to tone 1 and tone 4, transmission data of four bits are assigned to tone 2, and transmission data of five bits are assigned to tone 3. The 19 bits (information bits : sixteen bits, and redundant bits : three bits) form one frame. The number of bits assigned to the respective tones is larger than that of the illustrated data frame buffer because redundant bits required for error correction are added.

In this manner, one frame of the transmission data subjected to the tone ordering process is constituted as shown in, e.g., Fig. 30(b). More specifically, the tones are arranged in the descending order of the numbers of assigned bits, i.e., tone 0 (b0'), tone 5 (b1'), tone 1 (b2'), tone 4 (b3'), tone 2 (b4'), and tone 3 (b5'). Tone 0 and tone 5, tone 1 and tone 4, and tone 2 and tone 3 are constituted as 1-tone sets, respectively.

The frame processed as shown in Fig. 29 is encoded every tone set. When data d0 and d1 of the first tone set (tone 0 and tone 5) are input to terminals u1 and u2 of the trellis encoder 201, two information bits (u1 and u2) and one redundant bit (u0), i.e., a three-bit trellis code is output. One additional bit corresponds to the redundant bit.

When data d2, d3, d4, d5, and d6 of the second tone set (tone 4 and tone 1) are input to the terminals u1 and u2 and the terminals u3, u4, ... of the trellis encoder 201, two information bits (u1 and u2) and one redundant bit (u0), i.e., a three-bit trellis code and other 3-bit (u3, u4, ... ) data are output. One additional bit corresponds to the redundant bit.

Finally, when data d7, d0, d1, d2, d3, d4, d5, d6, and d7 of the third tone set (tone 3 and tone 2) are input to the terminals u1 and u2, terminals u4 and u5, ..., of the trellis encoder 201, two information bits (u1 and u2) and one redundant bit (u0), i.e., a three-bit trellis code and other 7-bit data (u3, u4, ...) are output. The one additional bit corresponds to the redundant bit.

As described above, when the tone ordering process and the encoding process are performed on the basis of an S/N ratio, transmission data are multiplexed every frame. In addition, on the transmission side, high-speed inverse Fourier transform (IFFT) is performed to the multiplexed transmission data. Thereafter, a digital waveform is converted into an analog waveform through a D/A converter. Finally, the analog data passes through a low-pass filter, and the final transmission data is transmitted onto a telephone line.

However, in the communication apparatus which employs the turbo encoder shown in Fig. 23(b), for example, an encoder (corresponding to recursive systematic convolutional encoder) and an interleaver have rooms for improvement. Turbo encoding using the conventional encoder and the conventional interleaver does not achieve optimum transmission characteristics which are close to the Shannon limit, i.e., optimum BER characteristics, disadvantageously.

The turbo encoder shown in Fig. 23(b) is employed in wide-band CDMA using the SS scheme. For example, the turbo encoder is not employed in a conventional communication apparatus which performs data transmission by the DMT modulation/demodulation scheme using a known transmission path such as a telephone line.

In the conventional communication apparatus which employs the trellis encoder shown in Fig. 29, a tone set is formed by two tones which are arranged in the descending order of the numbers of bits assigned in the tone ordering process. In addition, at least a three-bit turbo code consisting of information bits (two bits) and a redundant bit (one bit) must be assigned to the tone set. For this reason, transmission data cannot be assigned to a tone in which the number of bits which can be transmitted in the tone ordering process is set as one bit, so that transmission efficiency is deteriorated.

It is an object of the present invention to provide a method of and an apparatus for communications which can be applied to all communications using a multi-carrier modulation/demodulation schemes and a single-carrier modulation/demodulation scheme and which can realize considerable improvements of BER characteristics and transmission efficiency in comparison with a prior art.

DISCLOSURE OF THE INVENTION

The communication apparatus according to one aspect of the present invention comprises a turbo encoder. This turbo encoder includes a first recursive systematic convolutional encoder for convolutionally encoding two information bit sequences to output first redundant data; and a second recursive systematic convolutional encoder for convolutionally encoding the information bit sequences subjected to an inter leave process to output second redundant data. The first and second recursive systematic convolutional encoders are encoders which search all connection patterns constituting the encoders when a recursive systematic convolutional encoder is assumed to have a constraint length of "5" and the number of memories of "4", and which satisfy optimum conditions that an interval between two bits '1' of a self-terminated pattern is maximum in a specific block length and that a total weight in the pattern having the maximum interval is maximum in the specific block length.

The communication apparatus according to another aspect of the present invention comprises a turbo encoder. This turbo encoder includes a first recursive systematic convolutional encoder for convolutionally encoding two information bit sequences to output first redundant data; and a second recursive systematic convolutional encoder for convolutionally encoding the information bit sequences subjected to an interleave process to output second redundant data. The first and second recursive systematic convolutional encoders are encoders which search all connection patterns constituting the encoders when a recursive systematic convolutional encoder is assumed to have a constraint length of "4" and the number of memories of "3", and which satisfy optimum conditions that an interval between two bits '1' of a self-terminated pattern is maximum in a specific block length and that a total weight in the pattern having the maximum interval is maximum in the specific block length.

In the communication apparatuses according to the above-mentioned aspects, the turbo encoder comprises an interleaver. Assume that M is a prime number representing a value on an abscissa, N is a natural number representing a value on an ordinate, m is an integer, Ti is a number of tones, $S_{turbo}$ is a number of DMT symbols, and Tail is a number of bits for a terminating process. Then, the interleaver stores the information bit sequences in input buffers the number of which is given by $M \geq 2^m + 1$" $\times$ "N = [{Ti $\times$ S_{turbo}}-Tail}/2]/M$; shifts a random sequence of specific (M-1) bits generated by the prime number bit by bit in units of rows to generate random sequences of (M-1) types, maps minimum values on Mth bits of the respective rows in all the random sequences, makes mapping patterns of the Mth and subsequent rows equal to the mapping patterns of the first and subsequent rows to generate an M $\times$ N mapping pattern; maps information bit sequences each having an interleaving length on the M $\times$ N mapping pattern; and reads the information bit sequences subjected to mapping in units of columns to output the information bit sequences to the second recursive systematic convolutional encoder.

In the communication apparatuses according to the above-mentioned aspects, a tone set is formed by two or four tones in the descending order of the number of bits assigned in a tone ordering process, and at least a three-bit turbo code constituted by the two information bits or one of the two information bits and the first and second redundant bits is assigned to the tone set.

The communication method according to still another aspect of the present invention includes the turbo encoding step of convolutionally encoding two information bit sequences to output first redundant data together with the two information bit sequences and convolutionally encoding the information bit sequences subjected to an interleave process to output second redundant data, wherein the turbo encoding step is executed by using a recursive systematic convolutional encoder which satisfies optimum conditions that an interval between two bits '1' of a self-terminated pattern is maximum in a specific block length and that a total weight in the pattern having the maximum interval is maximum in the specific block length.

In the communication method according to the above-mentioned aspect, the turbo encoding step includes the bit sequence storing step of storing the information bit sequences in input buffers the number of which is given by "M (abscissa: prime number) $\geq 2^m + 1$" x "N (ordinate: natural number) = [{Ti $\times$ S_{turbo}}-Tail}/2]/M" (m denotes an integer, Ti denotes the number of tones, $S_{turbo}$ denotes the number of DMT symbols, and Tail denotes the number of bits for a terminating process), the mapping pattern generation step of shifting a random sequence of specific (M-1) bits generated by the prime number bit by bit in units of rows to generate random sequences of (M-1) types, mapping minimum values on Mth bits of the respective rows in all the random sequences, and generating mapping patterns of the Mth and subsequent rows equal to the mapping patterns of the first and subsequent rows to generate an M × N mapping pattern, the mapping step of mapping information bit sequences each having an interleaving length on the M × N mapping pattern, and the bit sequence reading step of reading the information bit sequences subjected to the mapping in units of columns.

In the communication method according to the above-mentioned aspect, a tone set is formed by two or four tones in the descending order of the number of bits assigned in a tone ordering process, and at least a three-bit turbo code constituted by the two information bits or one of the two information bits and the first and second redundant bits is assigned to the tone set.

BRIEF DESCRIPTION OF THE DRAWINGS

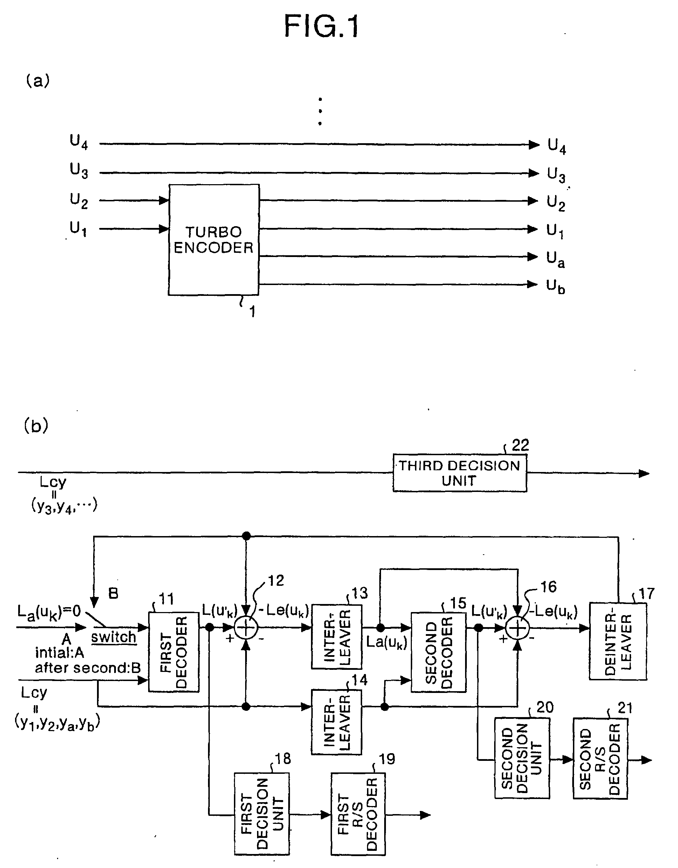

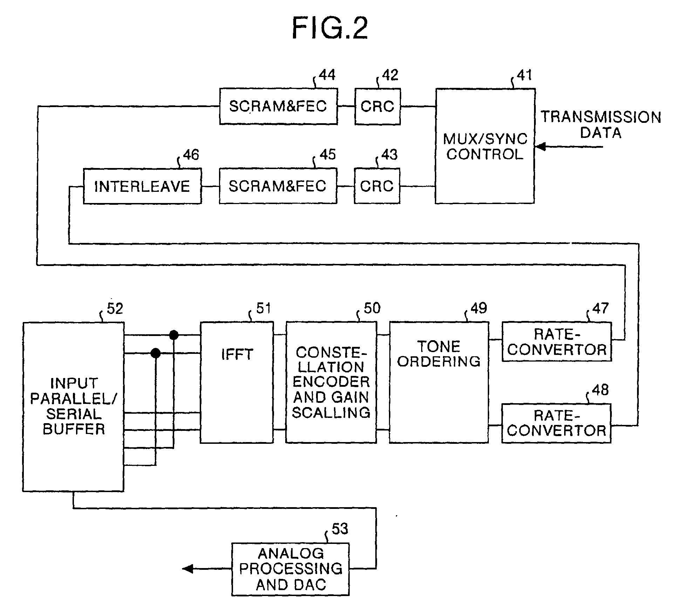

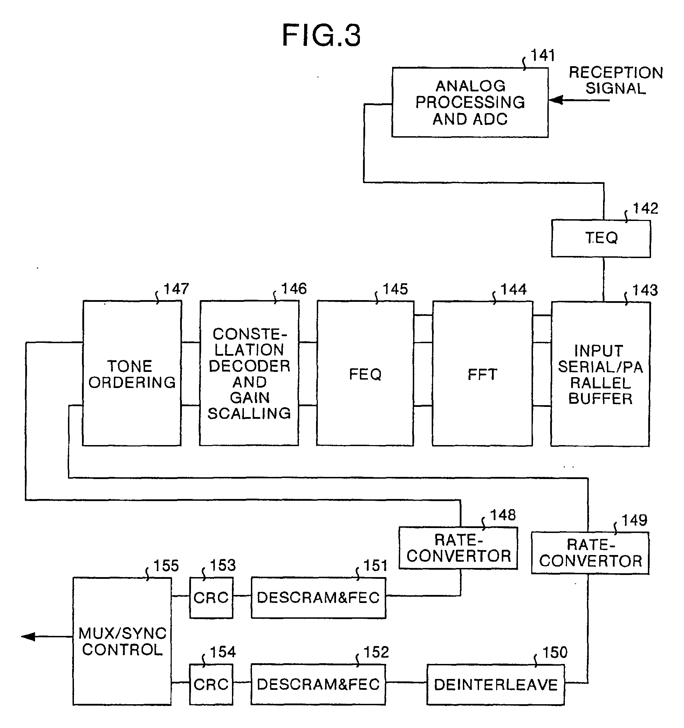

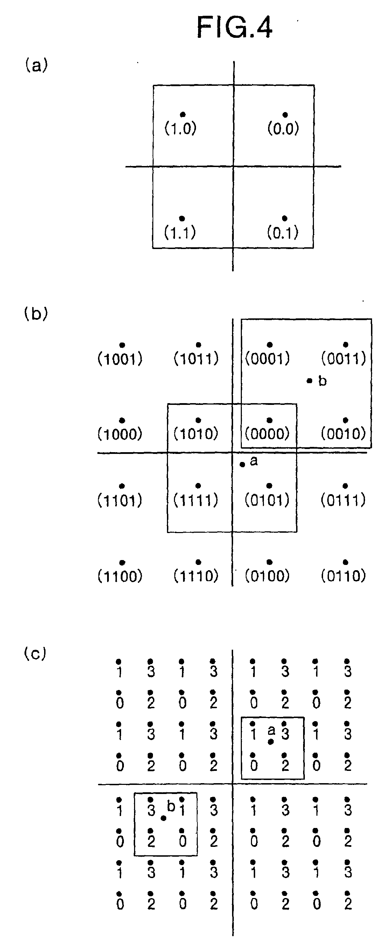

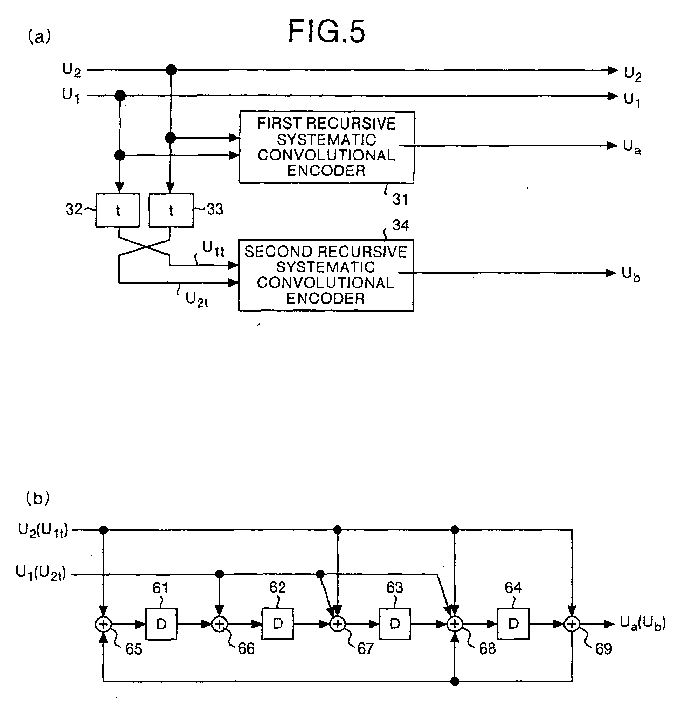

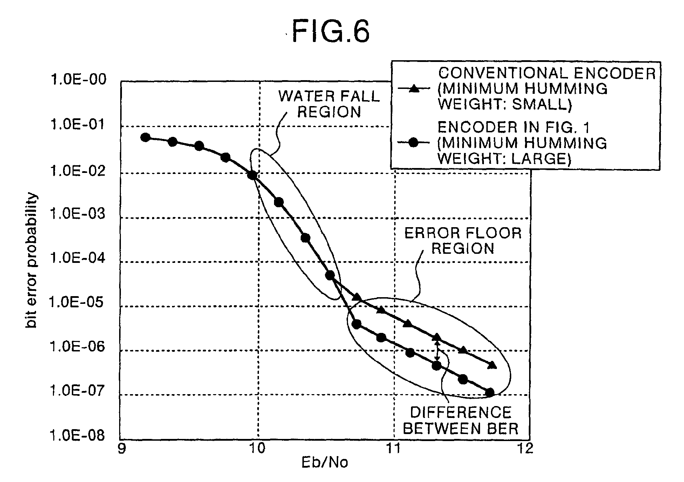

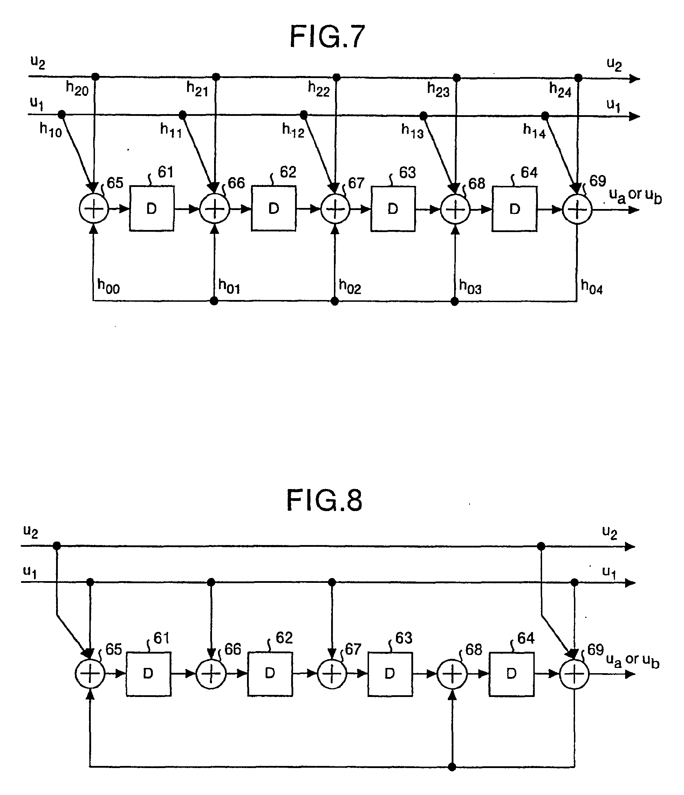

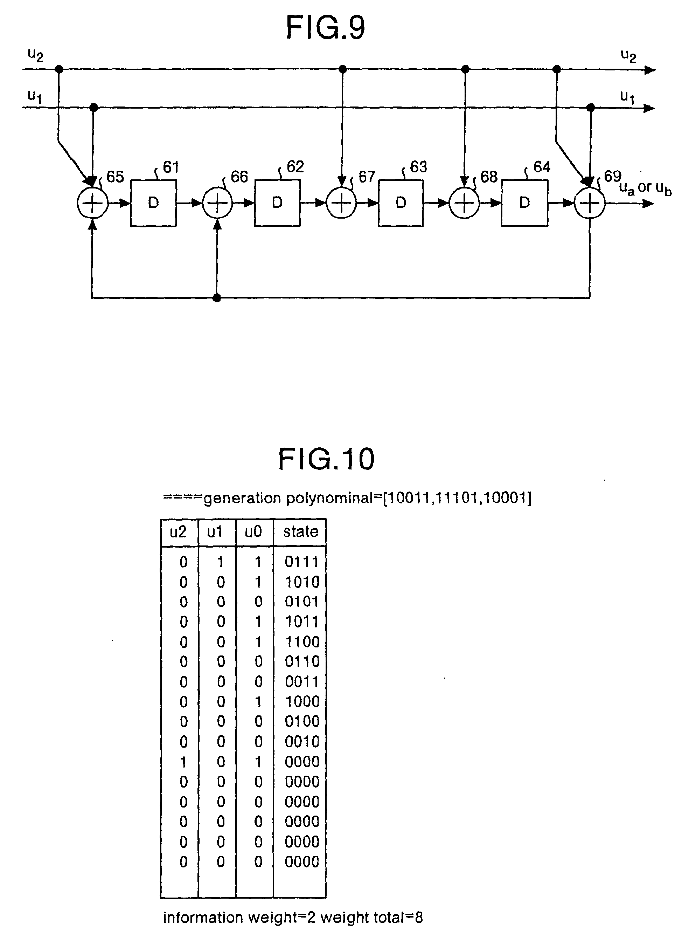

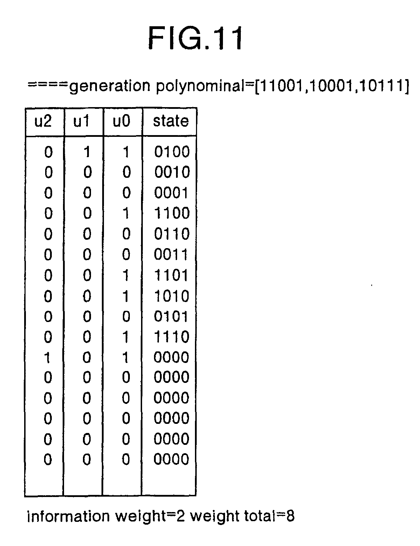

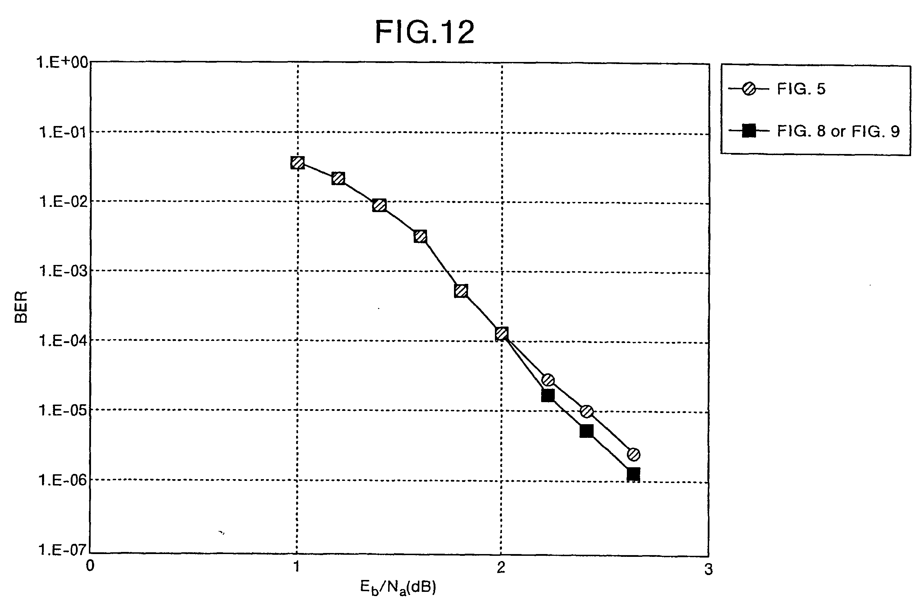

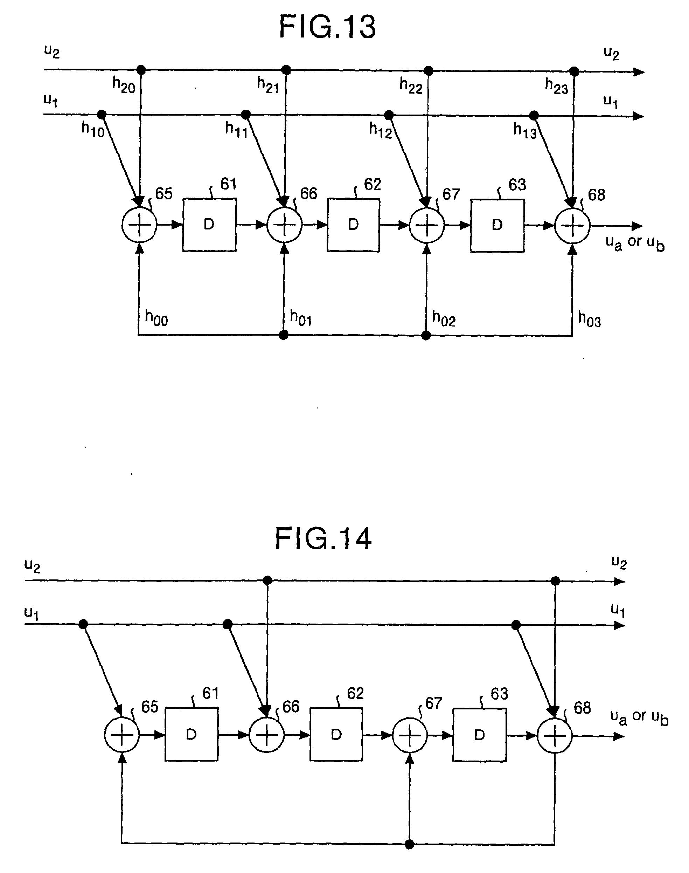

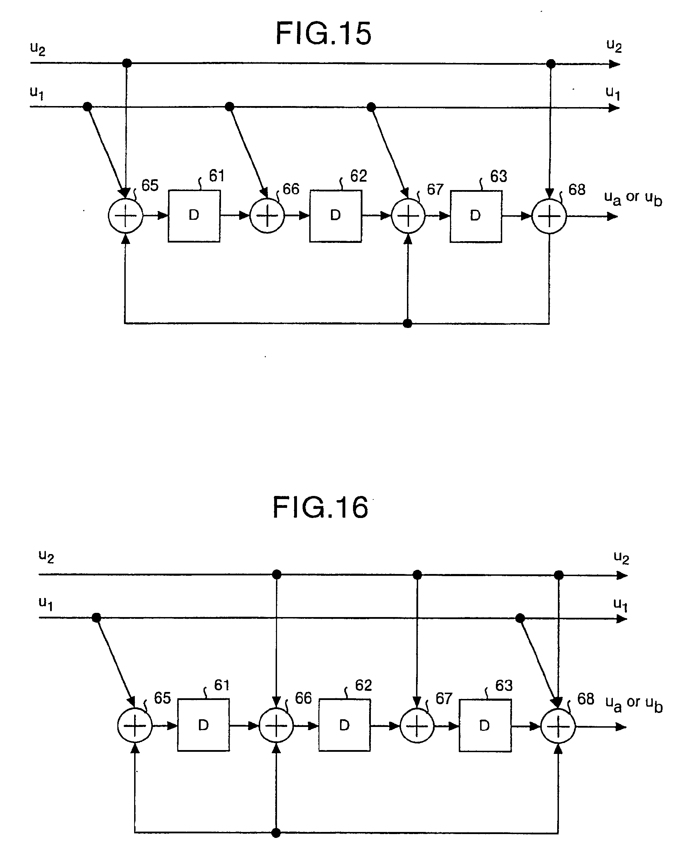

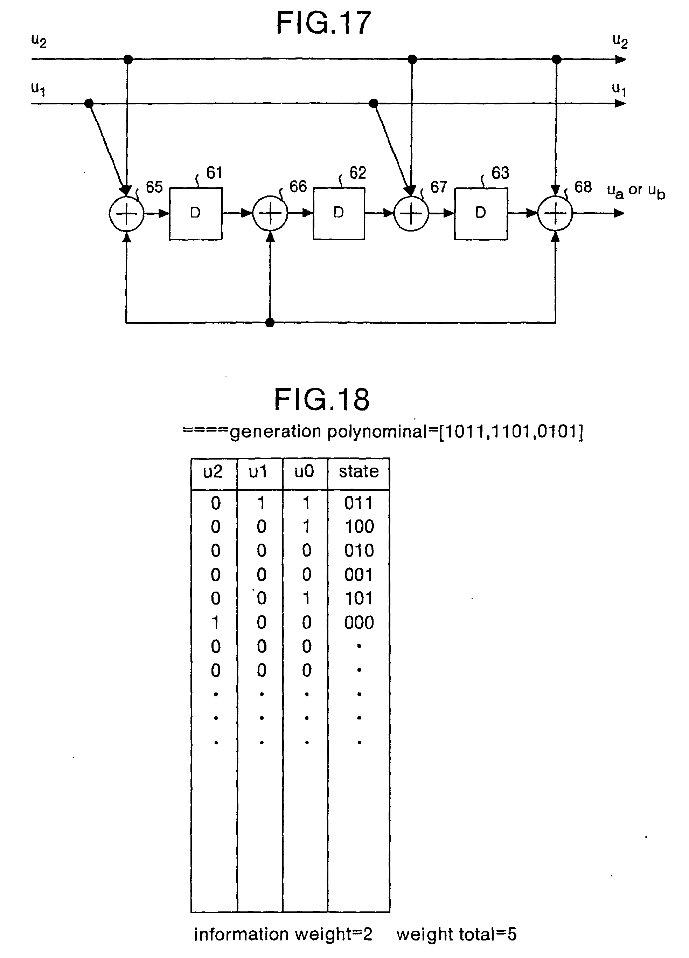

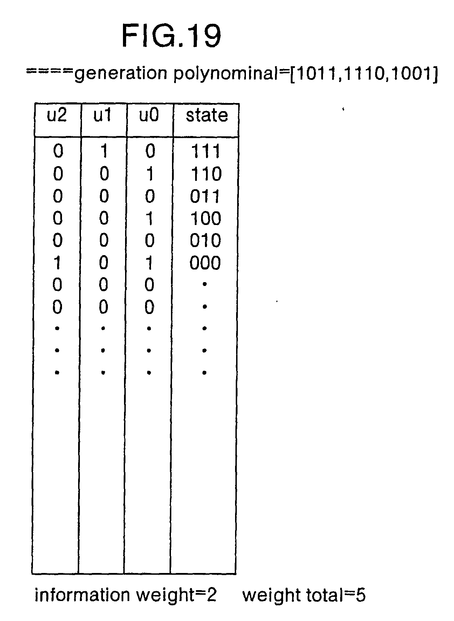

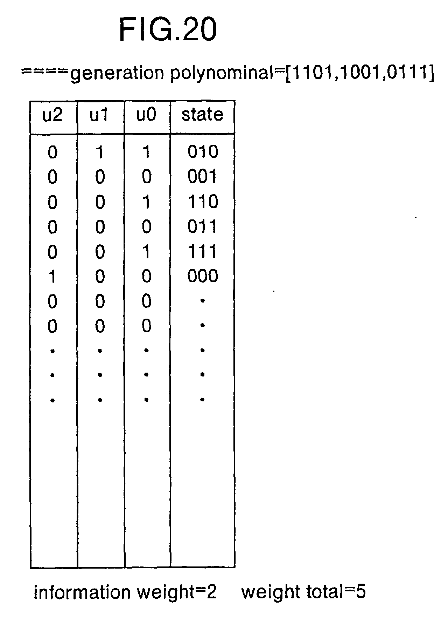

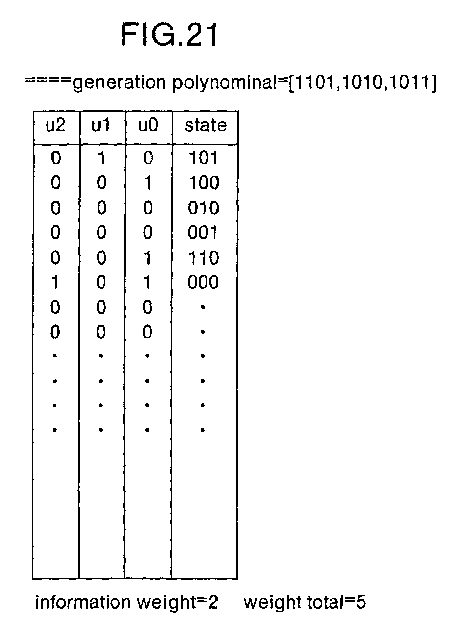

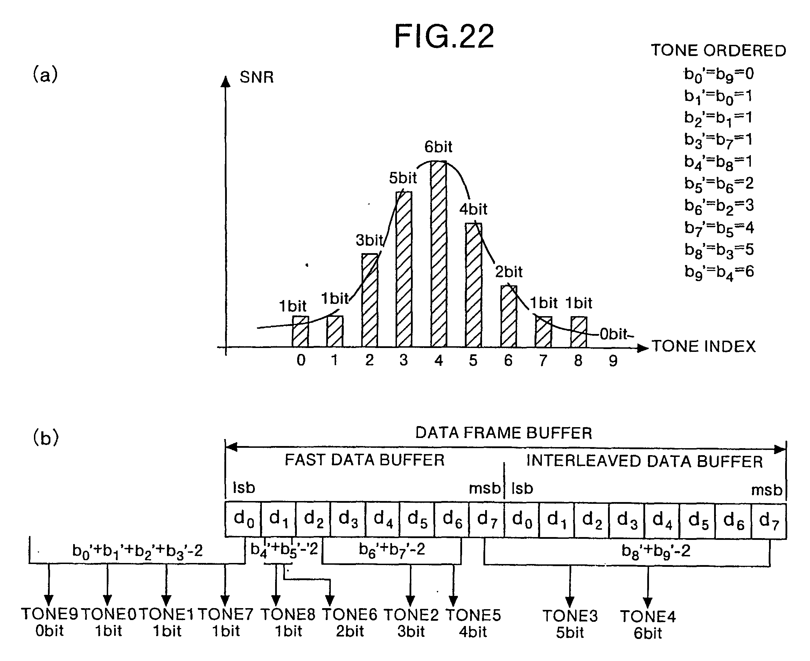

Fig. 1 includes diagrams showing the configurations of an encoder and a decoder used in a communication apparatus according to the present invention; Fig. 2 is a diagram showing the configuration of a transmission system of the communication apparatus according to the present invention; Fig. 3 is a diagram showing the configuration of a reception system of the communication apparatus according to the present invention; Fig. 4 includes diagrams showing signal point arrangements of various digital modulations; Fig. 5 is a diagram showing the configuration of a turbo encoder; Fig. 6 is a graph showing BER characteristics obtained when transmission data is decoded by using a turbo encoder and BER characteristics obtained when transmission data is decoded by using a conventional turbo encoder; Fig. 7 is a diagram showing an example of a connection of a recursive systematic convolutional encoder obtained when it is supposed that a constraint length : 4 and the number of memories: 4; Fig. 8 is a diagram showing an optimum recursive systematic convolutional encoder obtained by a searching method according to a first embodiment; Fig. 9 is a diagram showing an optimum recursive systematic convolutional encoder obtained by the searching method according to the first embodiment; Fig. 10 is a diagram showing intervals de of bits '1' of a self-terminated pattern in the recursive systematic convolutional encoder in Fig. 8 and a total weight; Fig. 11 is a diagram showing intervals de of bits '1' of a self-terminated pattern in the recursive systematic convolutional encoder in Fig. 9 and a total weight; Fig. 12 is a graph showing BER characteristics obtained when transmission data is decoded by using the turbo encoder shown in Fig. 5 and BER characteristics obtained when transmission data is decoded by using a turbo encoder which employs the recursive systematic convolutional encoder shown in Fig. 9; Fig. 13 is a diagram showing an example of a connection of a recursive systematic convolutional encoder obtained when it is supposed that a constraint +: 4 and the number of memories: 3; Fig. 14 is a diagram showing an optimum recursive systematic convolutional encoder obtained by a searching method according to a second embodiment; Fig. 15 is a diagram showing an optimum recursive systematic convolutional encoder obtained by a searching method according to the second embodiment; Fig. 16 is a diagram showing an optimum recursive systematic convolutional encoder obtained by a searching method according to second embodiment; Fig. 17 is a diagram showing an optimum recursive systematic convolutional encoder obtained by a searching method according to second embodiment; Fig. 18 is a diagram showing intervals de of bits '1' of a self-terminated pattern in the recursive systematic convolutional encoder in Fig. 14 and a total weight; Fig. 19 is a diagram showing intervals de of bits '1' of a self-terminated pattern in the recursive systematic convolutional encoder in Fig. 15 and a total weight; Fig. 20 is a diagram showing intervals de of bits '1' of a self-terminated pattern in the recursive systematic convolutional encoder in Fig. 16 and a total weight; Fig. 21 is a diagram showing intervals de of bits '1' of a self-terminated pattern in the recursive systematic convolutional encoder in Fig. 17 and a total weight; Fig. 22 is a diagram showing a tone ordering process according to fourth embodiment; Fig. 23 is a diagram showing the configuration of a conventional turbo encoder used in a transmission system; Fig. 24 is a diagram showing the configuration of a conventional turbo decoder used in a reception system; Fig. 25 is a diagram showing a process of an interleaver used in the conventional turbo encoder; Fig. 26 is a diagram showing a process of an interleaver used in the conventional turbo encoder; Fig. 27 is a diagram showing a process of an interleaver used in the conventional turbo encoder; Fig. 28 is a graph showing BER characteristics obtained when the conventional turbo encoder and the conventional turbo decoder are used; Fig. 29 is a diagram showing the configuration trellis encoder used in a conventional communication apparatus; and Fig. 30 includes a graph and a diagram showing a tone ordering process.

BEST MODE FOR CARRYING OUT THE INVENTION

Embodiments of the method of and the apparatus for communications according to the present invention will be described below with reference to the accompanying drawings. This invention is not limited to the embodiments.

First Embodiment:

Fig. 1 includes diagrams showing the configuration of an encoder (turbo encoder) used in a communication apparatus according to the present invention and a decoder (a combination of a turbo decoder, a hard decision unit, and an R/S (Reed-Solomon code) decoder). More specifically, Fig. 1(a) is a diagram showing the configuration of an encoder and Fig. 1(b) is a diagram showing the configuration of a decoder according to the first embodiment.

The communication apparatus according to the first embodiment comprises both the configurations of the encoder and the decoder, and has a highly precise data error correction capability, so that excellent transmission characteristics can be achieved in data communication and audio communication. In the first embodiment, for the descriptive convenience, the communication apparatus comprises both the configurations. However, for example, a transmitter comprising only the encoder of the two configurations may be supposed. On the other hand, a receiver comprising only the decoder may be supposed.

For example, in the encoder in Fig. 1(a), reference numeral 1 denotes a turbo encoder which can obtain performance which is close to the Shannon limit by employing a turbo coder as an error correction code. For example, in the turbo encoder 1, two information bits and two redundant bits are output with respect to an input of two information bits. In addition, in this case, respective redundant bits are generated to make correction capabilities for the information bits uniform in the reception side.

On the other hand, in the decoder in Fig. 1(b), reference numeral 11 denotes a first decoder for calculating a logarithmic likelihood ratio from a reception signal: Lcy (corresponding to reception signals: $y_2$, $y_1$, and $y_a$ (to be described later)), reference numerals 12 and 16 denote adders; reference numerals 13 and 14 denote interleavers, reference numeral 15 denotes a second decoder for calculating a logarithmic likelihood ratio from a reception signal: Lcy (corresponding to reception signals: $y_2$, $y_1$, and $y_b$ (to be described later)), reference numeral 17 denotes a deinterleaver, reference numeral 18 denotes a first decision unit for deciding an output from the first decoder 15 to output an estimation value of an original information bit sequence, reference numeral 19 denotes a first R/S decoder for decoding a Reed-Solomon code to output an information bit sequence having a higher precision, reference numeral 20 denotes a second decision unit for deciding an output from the second decoder 15 to output an estimation value of an original information bit sequence, reference numeral 21 denotes a second R/S decoder for decoding a Reed-Solomon code to output an information bit sequence having a higher precision, and reference 22 denotes a third decision unit for performing hard decision of Lcy (corresponding to reception signals: $y_3$, $y_4$, ..., (to be described later)) to output an estimation value of an original information bit sequence.

Before the operations of the encoder and the decoder are described, the basic operation of the communication apparatus according to the present invention will be briefly described below on the basis of the accompanying drawings. For example, as cable digital communication schemes for performing data communication by using the DMT (Discrete Multi Tone) modulation/demodulation scheme, xDSL communication schemes such as the ADSL (Asymmetric Digital Subscriber line) communication scheme for performing high-rate digital communication at several megabit/second by using a conventional telephone line and the HDSL (high-bit-rate Digital Subscriber line) are known. The schemes are standardized by ANSI T1.413 or the like. In the following description of the first embodiment, for example, it is assumed that a communication apparatus which can be applied to the ADSL is used.

Fig. 2 is a diagram showing the configuration of a transmission system of a communication apparatus according to the present invention. In Fig. 2, in the transmission system, transmission data is multiplexed by a multiplex/sync control (corresponding to a MUX/SYNC CONTROL in Fig. 2) 41, an error detection code is added to the multiplexed transmission data by a cyclic redundancy check (corresponding to a CRC: Cyclic redundancy check) 42 or 43. The resultant transmission data is added with an FEC code and subjected to a scramble process by forward an error correction (corresponding to a SCRAM & an FEC) 44 or 45.

There are two paths between the multiplex/sync control 41 to tone ordering 49. One of them is an interleaved data buffer (Interleaved Data Buffer) path including an interleave (INTERLEAVE) 46, and the other is a fast data buffer (Fast Data Buffer) path including no interleave. In this case, the interleaved data buffer path including the interleave process has a delay longer than that of the fast data buffer path.

Thereafter, the transmission data is subjected to a rate convert process by a rate converter (corresponding to a RATE-CONVERTER) 47 or 48 and subjected to a tone ordering process by the tone ordering (corresponding to TONE ORDERING) 49. On the basis of the transmission data subjected to the tone ordering process, constellation data is formed by a constellation encoder/gain scaling (corresponding to a CONSTELLATION AND GAIN SCALING) 50, and is subjected to inverse fast Fourier transform by an inverse fast Fourier transform unit (corresponding to an IFFT: Inverse Fast Fourier transform) 51.

Finally, the parallel data subjected to the Fourier transform is converted into serial data by an input parallel/serial buffer (corresponding to an INPUT PARALLEL/SERIAL BUFFER) 52. The digital waveform is converted into an analog waveform by the analog processing/digital-analog converter (corresponding to an ANALOG PROCESSING AND DAC) 53. The analog waveform is subjected to a filtering process, and the transmission data is transmitted onto a telephone line.

Fig. 3 is a diagram showing the configuration of a reception system of the communication apparatus according to the present invention. In Fig. 3, in the reception system, reception data (the transmission data) is subjected to a filtering process by an analog processing/analog-digital converter (corresponding to an ANALOG PROCESSING AND ADC in Fig. 3) 141. An analog waveform is converted into a digital waveform, and an adaptive equalizing process of a time domain is performed by a time domain equalizer (corresponding to a TEQ) 142.

The data subjected to the adaptive equalizing process of a time domain is converted from serial data to parallel data by an input serial/parallel buffer (corresponding to an INPUT SERIAL/PARALLEL BUFFER) 143. The parallel data is subjected to fast Fourier transform by a fast Fourier transform unit (corresponding to an FFT: Fast Fourier transform) 144. Thereafter, an adaptive equalizing process of a frequency domain is performed by a frequency domain equalizer (corresponding to an FEQ) 145.

The data subjected to the adaptive equalizing process of a frequency domain is converted by serial data by a decoding process (maximum likelihood method) and a tone ordering process performed by a constellation decoder/gain scaling (corresponding to a CONSTELLATION DECODER AND GAIN SCALING) 146 and a tone ordering (corresponding to TONE ORDERING) 147. Thereafter, a rate covert process by a rate converter (corresponding to a RATE-CONVERTER 148 or 149, a deinterleave process by a deinterleave (corresponding to a DEINTERLEAVE) 150, a FEC process and a descramble process by forward error correction (corresponding to DESCRAM & FEC) 151 or 152, and a process such as a cyclic redundancy check process by a cyclic redundancy check (corresponding to a redundancy check: CRC) 153 or 154 are performed. Finally, reception data is reproduced from a multiplex/sync control (corresponding to a MUX/SYNC CONTROL) 155.

The communication apparatus described above has two paths in each of the reception system and the transmission system. When the two paths are selectively used, or when the two paths are simultaneously operated, data communication having a short transmission delay and a high rate can be realized.

In the communication apparatus constituted as described above, the encoder shown in Fig. 1(a) is positioned at the constellation encoder/gain scaling 50 in the transmission system, and the decoder shown in Fig. 1(b) is positioned at the constellation decoder/gain scaling 146 in the reception system.

The operations of the encoder (transmission system) and the decoder (reception system) in the first embodiment will be described below with reference to the drawings. The operation of the encoder shown in Fig. 1(a) will be described first. In the first embodiment, as multi-value quadrature amplitude modulation (QAM: Quadrature Amplitude Modulation), for example, a 16 QAM scheme is employed. In the encoder according to the first embodiment, unlike a prior art in which turbo encoding is executed to all input data (4 bits), as shown in Fig. 1(a), turbo encoding is performed to only the input data of the two lower bits, the input data of the two upper bits are directly output.

The reason why the turbo encoding is executed to only the input data of the two lower bits will be described below. Fig. 4 includes signal point arrangements of various digital modulations. More specifically, Fig. 4(a) shows a signal point arrangement of a 4-phase PSK (Phase Shift Keying) scheme, Fig. 4 (b) shows a signal point arrangement of a 16 QAM scheme, and Fig. 4(c) shows a signal point arrangement of a 64 QAM scheme.

For example, in the signal point arrangements of all the modulation schemes, when reception signal points are located at positions a and b, in general, on the reception side, the most possible data is estimated by soft decision as an information bit sequence (transmission data). More specifically, a signal point which is closest to the reception signal point is decided as transmission data. However, at this time, for example, when the reception signal points a and b in Fig. 4 are noticed, in any cases (corresponding to Figs. 4(a), 4(b), and 4(c)), it is understood that the two lower bits of the four points which are closest to the reception signal point are given by (0, 0), (0, 1), (1, 0), and (1, 1), respectively. Therefore, in the first embodiment, turbo encoding having excellent error correction capability is performed to the two lower bits of the four signals (i.e., four points having the shortest inter-signal-point distance) which may be deteriorated in characteristics to perform soft decision on the reception side. On the other hand, the other upper bits the characteristics of which are deteriorated at a low possibility are directly output, and hard decision is performed on the reception side.

In this manner, in the first embodiment, the characteristics which may be deteriorated by multi-valuing can be improved, and the turbo encoding is performed to only the two lower bits of a transmission signal. For this reason, an amount of calculation can be considerably reduced in comparison with the prior art (see Fig. 23) in which turbo encoding is performed to all the bits.

Subsequently, an operation of the turbo encoder 1, shown in Fig. 1(a), for performing turbo encoding to transmission data: $u_1$ and $u_2$ of input two lower bits will be described below. For example, Fig. 5 is a diagram showing a configuration of the turbo encoder 1. More specifically, Fig. 5(a) is a diagram showing the block configuration of the turbo encoder 1, and Fig. 5(b) is a diagram showing an example of the circuit configuration of a recursive systematic convolutional encoder. In this case, it is assumed that the configuration in Fig. 5 (b) is used as the recursive systematic convolutional encoder. However, the recursive systematic convolutional encoder is not limited to the configuration. For example, the same recursive systematic convolutional encoder as that of the prior art or another known recursive systematic convolutional encoder may be used.

In Fig. 5(a), reference numeral 31 denotes a first recursive systematic convolutional encoder for convolutionally encoding transmission data: $u_1$ and $u_2$ corresponding to information bit sequences to output redundant data: $u_a$,

reference numerals 32 and 33 denote interleavers, and reference numeral 34 denotes a second recursive systematic convolutional encoder for convolutionally encoding data: $u_{1t}$ and $u_{2t}$ subjected to the interleave process to output redundant data: $u_b$. The turbo encoder 1 simultaneously outputs the transmission data: $u_1$ and $u_2$, the redundant data: $u_a$ obtained by encoding the transmission data: $u_1$ and $u_2$ by the process of the first recursive systematic convolutional encoder 31, and the redundant data: $u_b$ (having time different from the times of the other data) obtained by encoding the data: $u_{1t}$ and $u_{2t}$ subjected to the interleave process by the process of the second recursive systematic convolutional encoder 34.

In the recursive systematic convolutional encoder shown in Fig. 5(b), reference numerals 61, 62, 63, and 64 denote delay units, and reference numerals 65, 66, 67, 68, and 69 denote adders. In this recursive systematic convolutional encoder, the adder 65 of the first stage adds the input transmission data: $u_2$ (or the data: $u_{1t}$) and the feedback redundant data: $u_a$ (or the redundant data: $u_b$) to output the resultant data, the adder 66 of the second stage adds the input transmission data: $u_1$ (or the data: $u_{1t}$) and an output from the delay unit 61 to output the resultant data, the adder 67 of the third stage adds the input transmission input data: $u_1$ (or the data: $u_{2t}$), the transmission data: $u_2$ (or the data: $u_{1t}$), and an output from the delay unit 62 to output the resultant data, the adder 68 of the fourth stage adds the transmission data: $u_1$ (or the data: $u_{2t}$), the transmission data: $u_2$ (or data: $u_{1t}$), an output from the delay unit 63, and the feedback redundant data: $u_a$ (or the redundant data: $u_b$) to output the resultant data, and the adder 69 of the final stage adds the input transmission data: $u_2$ (or the data: $u_{1t}$) and an output from the delay unit 64 and finally outputs the redundant data: $u_a$ (redundant data: $u_b$).

In the turbo encoder 1, weights in the redundant bits are prevented from being offset such that the estimation precision of the transmission data: $u_1$ and $u_2$ on the reception side using the redundant data: $u_a$ and $u_b$ are uniform. More specifically, in order to make the estimation precision of the transmission data: $u_1$ and $u_2$ uniform, for example, the transmission data: $u_2$ is input to the adders 65, 67, 68, and 69 (see Fig. 5(b)) in the first recursive systematic convolutional encoder 31, and the data: $u_{2t}$ subjected to the interleave process is input to the adders 66 to 68 in the second recursive systematic convolutional encoder 34. On the other hand, the transmission data: $u_1$ is input to the adders 66 to 68 in the first recursive systematic convolutional encoder 31, and the data: $u_{1t}$ subjected to the interleave process is input to the adders 65, 67, 68, and 69 in the second recursive systematic convolutional encoder 34. For this reason, the number of delay units through which the sequence of the transmission data: $u_1$ passes until the sequence is output is equal to the number of delay units through which the sequence of the transmission data: $u_2$ passes until the sequence is output.

As described above, when the encoder shown in Fig. 1(a) is used, as an effect of interleave, error correction capability can be improved for burst data errors. In addition, an input of the sequence of the transmission data: $u_1$ and an input of the sequence of the transmission data: $u_2$ are exchanged between the first recursive systematic convolutional encoder 31 and the second recursive systematic convolutional encoder 34, so that the estimation precision of the transmission data: $u_1$ and $u_2$ on the reception side can be uniformed.

The operation of the decoder shown in Fig. 1(b) will be described below. In the first embodiment, for example, a case in which the 16 QAM scheme is employed as multi-value quadrature amplitude modulation (QAM) will be described below. In the decoder according to the first embodiment, turbo decoding is performed to the two lower bits of reception data, original transmission data is estimated by soft decision. With respect to the other upper bits, reception data is subjected to hard decision by the third decision unit 22 to estimate the original transmission data. Reception signals Lcy: $y_4$, $y_3$, $y_2$, $y_1$, $y_a$, and $y_b$ are signals are signals which give influence such as noise of a transmission path or fading to the outputs $u_4$, $u_3$, $u_2$, $u_1$, $u_a$, and $u_b$ on the transmission side.

In the turbo decoder which receives the reception signals Lcy: $y_2$, $y_1$, $y_a$, and $y_b$, the first decoder 11 extracts the reception signals Lcy: $y_2$, $y_1$, and $y_a$ and calculates logarithmic likelihood ratios: $L(u_{1k}')$ and $L(u_{2k}')$ of information bits (corresponding to original transmission data: $u_{1k}$ and $u_{2k}$) : $u_{1k}'$ and $u_{2k}$ estimated from these reception signals (k represents time). That is, in this case, the probability that $u_{2k}$ to the probability that $u_{2k}$ is 0 is 0 and the probability that $u_{1k}$ to the probability that $u_{1k}$ is 0 is 1 are calculated. In the following description, $u_{1k}$ and $u_{2k}$ are simply called $u_k$, and $u_{1k}'$ and $u_{2k}'$ are simply called $u_k'$.

In Fig. 1(b), $Le(u_k)$ denotes external information, and $La(u_k)$ is prior information which is previous external information. As a decoder for calculating a logarithmic likelihood ratio, for example, a known maximum posterior probability decoder (MAP algorithm: Maximum A-Posteriori) is often used. However, for example, a known viterbi decoder may be used.

In the adder 12, external information: $Le(u_k)$ to the second decoder 15 is calculated from the logarithmic likelihood ratio which is the calculated result. Since prior information is not calculated in the first decoding, $La(u_k) = 0$ is satisfied.

In the interleavers 13 and 14, the reception signals Lcy and the external information: $Le(u_k)$ are rearranged. In the second decoder 15, as in the first decoder 11, on the basis of the reception signals Lcy and the previously calculated prior information $La(u_k)$, a logarithmic likelihood ratio $L(u_k')$. Thereafter, in the adder 16, as in the adder 12, the external information: $Le(u_k)$ is calculated. At this time, the pieces of external information rearranged by the deinterleaver 17 is fed back to the first decoder 11 as prior information: La ($u_k$).

In the turbo decoder, the above process is repeatedly executed a predetermined number of times (the number of times of iteration) , so that a logarithmic likelihood ratio having high precision is calculated. The first decision unit 18 and the second decision unit 20 decide signals on the basis of the logarithmic likelihood ratio to estimate original transmission data. More specifically, for example, when the logarithmic likelihood ratio is given by "$L(u_k') > 0$", the estimated information bit: $u_K'$ is decided as 0. When the logarithmic likelihood ratio is given by "$L(u_k') \leq 0$", the estimated information bit: $u_k'$ is decided as 0. The reception signals Lcy: $y_3$, $y_4$, ... which are simultaneously received are subjected to hard decision by using the third decision unit 22.

Finally, in the first R/S decoder 19 and the second R/S decoder 21, error check using Reed-Solomon codes is performed by a predetermined method. When it is decided that the estimation precision exceeds a specific standard, the repeated process is ended. Error correction of the original transmission data estimated by the decision units is performed by using the Reed-Solomon codes to output transmission data having higher estimation precision.

A method of estimating original transmission data by the first R/S decoder 19 and the second R/S decoder 21 will be described below with reference to concrete examples. As concrete examples, three methods will be described below. As the first method, for example, each time original data is estimated by the first decision unit 18 or the second decision unit 20, the corresponding first R/S decoder 19 and the corresponding second R/S decoder 21 alternately check errors. When one of the R/S decoders decides that "there is no error", the repeated process performed by the turbo encoder is ended. Error correction for the estimated original transmission data is performed by Reed-Solomon codes, so that transmission data having higher estimation precision is output.

As the second method, each time the original data is estimated by the first decision unit 18 or the second decision unit 20, the corresponding first R/S decoder 19 and the corresponding second R/S decoder 21 alternately check errors. When both the R/S decoders decide that "there is no error", the repeated process performed by the turbo encoder is ended. Error correction for the estimated original transmission data is performed by Reed-Solomon codes, so that transmission data having higher estimation precision is output.

The third method solves a problem in which error correction is performed when the repeated process is not performed because the first and second methods erroneously decide that "there is no error". For example, the repeated process is performed a predetermined number of times to reduce a bit error rate to some extent, and error correction for the estimated original transmission data is performed by using Reed-Solomon codes, so that transmission data having higher estimation precision is output.

As described above, when the decoder shown in Fig. 1(b) is used, even though constellations increase in number with multi-valuing of a modulation scheme, a reduction of the number of times of a soft decision process having a large amount of calculation and preferable transmission characteristics can be realized by arranging the turbo decoder for performing a soft decision process to the two lower bits of the reception signals the characteristics of which may be deteriorated and error correction by Reed-Solomon codes and the decision unit for performing hard decision to other bits of the reception signals.

When transmission data is estimated by using the first R/S decoder 19 and the second R/S decoder 21, the number of times of iteration can be reduced, and the number of times of the soft decision process having a large amount of calculate and a process time thereof can be further reduced. It is generally known that, in a transmission path in which a random error and a burst error exist, excellent transmission characteristics can be obtained by using R-S codes (Reed-Solomon) for performing error correction in units of symbols, other known error correction codes, and the like.

BER (Bit Error Rate) characteristics obtained when transmission data is decoded by using the turbo encoder shown in Fig. 5 is compared with BER characteristics obtained when transmission data is decoded by using the conventional turbo encoder shown in Fig. 23 are compared with each other. Fig. 6 is a graph showing both the BER characteristics. For example, when the performance of a turbo code is determined by using a BER, in a high $E_b/N_o$ region, e.g., an error floor region, the bit error rate of the turbo encoder shown in Fig. 5 is lower than the bit error rate of the conventional encoder. As is understood from the comparison and examination results in Fig. 6, the performance of the turbo encoder shown in Fig. 5 is apparently better than the prior art shown in Fig. 23.

In this manner, as the recursive systematic convolutional encoder (encoder) used in the turbo encoder 1, for example, as shown in Fig. 5(b), a configuration which inputs at least one of sequences of transmission data to the adder of the final stage, so that the influence of the transmission data can be more strongly reflected on redundant data. More specifically, demodulation characteristics on the reception side can be considerably improved in comparison with the prior art.

In the description up to now, it is assumed that the communication apparatus employs a turbo encoder satisfies the following equation:

$$g = [h_0, h_1, h_2]$$

$$=[10011, 01110, 10111] \tag{5}$$

(see Fig. 7 (to be described later) for the expression of Equation (5)). The configuration in which at least one of two information bit sequences input to the turbo encoder is input to the adder of the final stage is employed, so that demodulation characteristics on the reception side are improved. In the following description, a turbo encoder which employs a recursive systematic convolutional encoder according to the present invention which can further improve demodulation characteristics is used, so that more optimum transmission characteristics which are close to the Shannon limit, i.e., optimum BER characteristics can be obtained.

A method of searching an optimum recursive systematic convolutional encoder according to the first embodiment will be described below. In the embodiment, as an example of the recursive systematic convolutional encoder, an encoder having a constraint length: 5 (the number of adders) and the number of memories: 4 is supposed. When the optimum recursive systematic convolutional encoder is searched, all connection patterns of a recursive systematic convolutional encoder which can be employed when information bits: u1 and u2 are input are searched, and a recursive systematic convolutional encoder which satisfy the following optimum conditions is detected.

Fig. 7 is a diagram showing an example of a connection of the recursive systematic convolutional encoder when a constraint length: 5 and the number of memories: 4 are supposed. For example, the recursive systematic convolutional encoder is a recursive systematic convolutional encoder obtained when the information bits: u1 and u2 are input to all the adders, and redundant bit: ua (or ub) is fed back to the other adders of other stages than the final stage. This encoder is expressed by the following equation:

$$g = [h_0, h_1, h_2]$$

$$=[11111, 11111, 11111] \tag{6}$$

Optimum conditions in searching a recursive systematic convolutional encoder will be described below.

1) A pattern in which a block length L, an input weight 2, and an interval de between two bits '1' of a self-terminated (state in which all the delay units 61, 62, 63 and 64 are 0) is maximum (example: interval de = 10).
More specifically,

the number of generated self-terminated patterns: K

$$= L/de \text{ (where the figures below the decimal point are omitted)} \tag{7}$$

is minimum.
2) A pattern in which a total weight is maximum in the above pattern (example: total weight = 8).

Figs. 8 and 9 show optimum recursive systematic convolutional encoders obtained by the searching method of the embodiment. When a constraint length: 5 and the number of memories: 4 are supposed, the recursive systematic convolutional encoders which are shown in Figs. 8 and 9 and in which interval de = 10 and total weight = 8 (see Fig. 11 and Fig. 12 (to be described later)) satisfy the optimum conditions.

More specifically, Fig. 8 shows the recursive systematic convolutional encoder which satisfies the following equation:

$$g = [h_0, h_1, h_2]$$

$$=[10011, 11101, 10001] \qquad \ldots (8)$$

Fig. 9 shows the recursive systematic convolutional encoder which satisfies the following equation:

$$g = [h_0, \ h_1, \ h_2]$$

$$= [11001, \ 10001, \ 10111] \qquad \ldots \ (9)$$

Figs. 10 and 11 are diagrams showing self-terminatedpatterns of the recursive systematic convolutional encoders in Figs. 8 and 9 which satisfy the above optimum conditions, i.e., intervals de between bits '1' of a self-terminated pattern and total weights: total weight.

Fig. 12 is a graph showing BERcharacteristics obtained when transmission data is decoded by using the turbo encoder shown in Fig. 5 and BER characteristics obtained when transmission data are decoded by using a turbo encoder which employs the recursive systematic convolutional encoders shown in Figs. 8 and 9. For example, when the performance of the turbo encoder is determined by using a BER, in a high $E_b/N_o$ region, the turbo encoder which employs the recursive systematic convolutional encoders shown in Figs. 8 and 9 has a bit error rate which is lower than the bit error rate of the turbo encoder shown in Fig. 5. More specifically, from the comparison and examination results, it can be understood that the turbo encoder according to the first embodiment in which the BER characteristics of the high $E_b/N_o$ are low has performance higher than that of the turbo encoder shown in Fig. 5.

In this manner, in the first embodiment, when a recursive systematic convolutional encoder having a constraint length: 5 and the number of memories: 4 is supposed as an example, an optimum recursive systematic convolutional encoder is determined such that a total weight is maximum in a pattern in which a block length L, an input weight 2, an interval de between bits '1' of a self-terminated pattern is maximum, and a total weight is maximum in the pattern in which the interval de is maximum. In addition, since the recursive systematic convolutional encoder is employed as a turbo encoder, the BER characteristics on the reception side can be considerably improved.

When the recursive systematic convolutional encoders shown in Fig. 8 and Fig. 9 are used as turbo encoder, tail bits are processed as described below.

For example, the recursive systematic convolutional encoder shown in Fig. 8 satisfies the following equations:

$$u1^{(1)} = S0^{(0)} + S3^{(0)}$$

$$u2^{(1)} = S0^{(0)} + S2^{(0)}$$

$$u1^{(2)} = S3^{(0)}$$

$$u2^{(2)} = S0^{(0)} + S1^{(0)} \qquad \ldots \ (10)$$

On the other hand, the recursive systematic convolutional encoder shown in Fig. 9 satisfies the following equations:

$$u1^{(1)} = S0^{(0)} + S1^{(0)} + S3^{(0)}$$

$$u2^{(1)} = S2^{(0)}$$

$$u1^{(2)} = 1^{(0)} + S2^{(0)} + S3^{(0)}$$

$$u2^{(2)} = S1^{(0)} + S2^{(0)} \qquad \ldots \ (11)$$

In these equations, '+' represents an exclusive OR.

A method of calculating the equations of the tail bits will be described below. As an example, a method of calculating Equation (10) will be described. For example, when information bits obtained when a pattern is self-terminated are represented by $u1^{(2)}$ and $u2^{(2)}$, when first previous information bits obtained when the pattern is self-terminated are represented by $u1^{(1)}$ and $u2^{(1)}$, when memory values obtained when the pattern is self-terminated are represented by $S0^{(2)}$, $S1^{(2)}$, $S2^{(2)}$, and $S3^{(2)}$, when first previous information bits obtained when the pattern is self-terminated are represented by $S0^{(1)}$, $S1^{(1)}$, $S2^{(1)}$, and $S3^{(1)}$, and when second previous information bits obtained when the pattern is self-terminated are represented by S0$^{(0)}$, S1$^{(0)}$, S2$^{(0)}$, and S3$^{(0)}$, with reference to Fig. 8, the following equations are established:

$$S0^{(1)} = u1^{(1)} + u2^{(1)} + (u1^{(1)} + u2^{(1)} + S3^{(0)})$$

$$= S3^{(0)}$$

$$S1^{(1)} = u1^{(1)} + S0^{(0)}$$

$$S2^{(1)} = u1^{(1)} + S1^{(0)}$$

$$S3^{(1)} = S2^{(0)} + (u1^{(1)} + u2^{(1)} + S3^{(0)}) \qquad \ldots (12)$$

With reference to Fig. 8, the following equations obtained when the process is advanced by one block are established:

$$S0^{(2)} = S3^{(1)}$$

$$= S2^{(0)} + u1^{(1)} + u2^{(1)} + S3^{(0)}$$

$$S1^{(2)} = u1^{(2)} + S0^{(1)}$$

$$= u1^{(2)} + S3^{(1)}$$

$$S2^{(2)} = u1^{(2)} + S1^{(1)}$$

$$= u1^{(2)} + u1^{(1)} + S3^{(0)}$$

$$S3^{(2)} = S2^{(1)} + (u1^{(2)} + u2^{(2)} + S3^{(1)})$$

$$= u1^{(1)} + S1^{(0)} + u1^{(2)} + u2^{(2)} + S2^{(0)} + u1^{(1)}$$

$$+ 2^{(1)} + S3^{(1)}$$

$$u2^{(1)} + u1^{(2)} + u2^{(2)} + S1^{(0)} + S2^{(0)} + S3^{(0)} \ldots (13)$$

Finally, when u1$^{(1)}$, u2$^{(1)}$, u1$^{(2)}$, and u2$^{(2)}$ are solved on the basis of the Equations (12) and (13), an equation of tail bits of Equation (10) is obtained.

Second Embodiment:

In the first embodiment described above, as an example, the recursive systematic convolutional encoder having a constraint length: 5 (the number of adders) and the number of memories: 4 is supposed. However, in the second embodiment, in order to provide an inexpensive communication apparatus, a turbo encoder which employs a recursive systematic convolutional encoder having a constraint length: 4 and the number of memories: 3 is used to obtain optimum transmission characteristics which are close to the Shannon limit, i.e., optimum BER characteristics.
A method of searching an optimum recursive systematic convolutional encoder according to the second embodiment will be described below. In the second embodiment, as described above, as an example of the recursive systematic convolutional encoder, an encoder having a constraint length: 4 and the number of memories: 3 is supposed. When the optimum recursive systematic convolutional encoder is searched, all connection patterns of the recursive systematic convolutional encoder which can be employed when information bits: u1 and u2 are input are searched, and a recursive systematic convolutional encoder which the following optimum conditions is detected.

Fig. 13 is a diagram showing an example of a connection of the recursive systematic convolutional encoder when a constraint length: 4 and the number of memories: 3 are supposed. For example, the recursive systematic convolutional encoder is obtained when the information bits: u1 and u2 are input to all the adders and when a redundant bit: ua (or ub) is fed back to other adders than the adder of the final stage. This encoder is expressed as follows:

$$g = [h_0, \ h_1, \ h_2]$$

$$= [1111, \ 1111, \ 1111] \qquad \qquad \ldots (14)$$

Optimum conditions in searching a recursive systematic convolutional encoder will be described below.

1) A pattern in which a block length L, an input weight 2, and an interval de between two bits '1' of a self-terminated (state in which all the delay units 61, 62, 63 and 64 are 0) is maximum (example: interval de = 10). More specifically, the Equation (7) is minimum.
2) At the same time, a pattern having the maximum total weight in the patterns.

Fig. 14, Fig. 15, Fig. 16, and Fig. 17 show optimum recursive systematic convolutional encoders obtained by the searching method according to the second embodiment. When a constraint length: 4 and the number of memories: 3 are supposed, the recursive systematic convolutional encoders each having interval de = 10 and total weight = 8 (see Fig. 11 and Fig. 12 (to be described later)) shown in Figs. 14 to Fig. 17 satisfy the following optimum conditions.

More specifically, Fig. 14 shows the recursive systematic convolutional encoder which satisfies the following equation:

$$g = [h_0, \ h_1, \ h_2]$$

$$= [1011, \ 1101, \ 0101] \qquad \qquad \ldots (15)$$

Fig. 15 shows the recursive systematic convolutional encoder which satisfies the following equation:

$$\dot{g} = [h_0, \ h_1, \ h_2]$$

$$= [1011, \ 1110, \ 1001] \qquad \qquad \ldots (16)$$

Fig. 16 shows the recursive systematic convolutional encoder which satisfies the following equation:

$$g = [h_0, \ h_1, \ h_2]$$

$$= [1101, \ 1001, \ 0111] \qquad \qquad \ldots (17)$$

Fig. 17 shows the recursive systematic convolutional encoder which satisfies the following equation:

$$g = [h_0, \ h_1, \ h_2]$$

$$= [1101, \ 1010, \ 1011] \qquad \qquad \ldots (18)$$

Fig. 18, Fig. 19, Fig. 20 and Fig. 21 are diagrams showing the self-terminated patterns of the recursive systematic convolutional encoders in Fig. 14 to Fig. 17, i.e., intervals de between bits '1' of self-terminated patterns and total weights: total weight.

In this manner, in the second embodiment, as an example, when a recursive systematic convolutional encoder having a constraint length: 4 and the number of memories: 3 is supposed, an optimum recursive systematic convolutional encoder is determined such that a block length L, an input weight 2, an interval de between bits '1' of a self-terminated pattern is maximum, and a total weight in the pattern in which the interval de is maximum is maximum. In addition, this recursive systematic convolutional encoder is employed as a turbo encoder. For this reason, BER characteristics on the reception side can be improved in comparison with the BER characteristics of a conventional turbo encoder. In addition, since a circuit scale can be considerably made smaller than that of first embodiment, an inexpensive communication can be realized.

When the recursive systematic convolutional encoders shown in Fig. 14 to Fig. 17 are used as turbo encoders, tail bits are processed as described below.

For example, the recursive systematic convolutional encoder shown in Fig. 14 satisfies the following equations:

$$u1^{(1)} + u2^{(1)} + u2^{(2)} = S1^{(0)} + S2^{(0)}$$

$$u2^{(1)} + u1^{(2)} + u2^{(2)} = S2^{(0)}$$

$$u1^{(2)} + u2^{(2)} = S0^{(0)} + S1^{(0)} + S2^{(0)} \qquad (19)$$

The recursive systematic convolutional encoder shown in Fig. 15 satisfies the following equations:

$$u1^{(1)} + u2^{(1)} + u1^{(2)} = S1^{(0)} + S2^{(0)}$$

$$u1^{(1)} + u1^{(2)} = S2^{(0)}$$

$$u2^{(1)} + u1^{(2)} + u2^{(2)} = S0^{(0)} + S1^{(0)} + S2^{(0)} \qquad (20)$$

The recursive systematic convolutional encoder shown in Fig. 16 satisfies the following equations:

$$u2^{(1)} + u2^{(2)} = S1^{(0)}$$

$$u1^{(2)} = S1^{(0)} + S2^{(0)}$$

$$u1^{(1)} + u2^{(2)} = S0^{(0)} + S2^{(0)} \qquad (21)$$

The recursive systematic convolutional encoder shown in Fig. 17 satisfies the following equations:

$$u1^{(1)} + u2^{(1)} + u1^{(2)} = S1^{(0)}$$

$$u2^{(1)} + u2^{(2)} = S1^{(0)} + S2^{(0)}$$

$$u2^{(1)} + u1^{(2)} + u2^{(2)} = S0^{(0)} + S2^{(0)} \qquad (22)$$

In these equations, '+' represents an exclusive OR.

A method of calculating the equations of the tail bits will be described below. As an example, a method of calculating Equation (19) will be described. For example, when information bits obtained when a pattern is self-terminated are represented by $u1^{(2)}$ and $u2^{(2)}$, when first previous information bits obtained when the pattern is self-terminated are represented by $u1^{(1)}$ and $u2^{(1)}$, when memory values obtained when the pattern is self-terminated are represented by $S0^{(2)}$, $S1^{(2)}$, and $S2^{(2)}$, when first previous memory values obtained when the pattern is self-terminated are represented by $S0^{(1)}$, $S1^{(1)}$, and $S2^{(1)}$, and when second previous memory values obtained when the pattern is self-terminated are represented by $S0^{(0)}$, $S1^{(0)}$, and $S2^{(0)}$, with reference to Fig. 14, the following equations are established:

$$S0^{(1)} = u1^{(1)} + (u1^{(1)} + u2^{(1)} + S2^{(1)})$$

$$S1^{(1)} = u1^{(1)} + u2^{(1)} + S0^{(0)}$$

$$S2^{(1)} = (u1^{(1)} + u2^{(1)} + S2^{(0)}) + S1^{(0)}) \tag{23}$$

With reference to Fig. 14, the following equations obtained when the process is advanced by one block are established:

$$S0^{(2)} = u1^{(2)} + u1^{(2)} + u2^{(2)} + S2^{(1)}$$

$$= u1^{(2)} + u1^{(2)} + u2^{(2)} + u1^{(1)} + u2^{(1)} + S2^{(0)} + S1^{(0)}$$

$$= u1^{(1)} + u2^{(1)} + u2^{(2)} + S2^{(0)} + S1^{(0)}$$

$$S2^{(2)} = u1^{(2)} + u2^{(2)} + S0^{(1)}$$

$$= u1^{(2)} + u2^{(2)} + u1^{(1)} + u1^{(1)} + u2^{(1)} + S2^{(0)}$$

$$= u2^{(1)} + u1^{(2)} + u2^{(2)} + S2^{(0)}$$

$$S2^{(2)} = u1^{(2)} + u2^{(2)} + S2^{(1)} + S1^{(1)}$$

$$= u1^{(2)} + u2^{(2)} + u1^{(1)} + u2^{(1)} + S2^{(0)} + S1^{(0)} + u1^{(1)}$$

$$+ u2^{(2)} + S0^{(0)} \qquad \ldots (24)$$

Finally, when $u1^{(1)}$, $u2^{(1)}$, $u1^{(2)}$, and $u2^{(2)}$ are solved on the basis of the Equations (23) and (24), an equation of tail bits of Equation (19) is obtained.

Third Embodiment:

In the first or second embodiment described above, it is assumed that the same interleavers are used in all the configurations, and demodulation characteristics on the reception side are improved by the difference between the recursive systematic convolutional encoders. In the following description, by using interleavers according to the third embodiment, demodulation characteristics on the reception side are considerably improved, and optimum transmission characteristics which are close to the Shannon limit, i.e., optimum BER characteristics are obtained.

A process of rearranging information bit sequences at random by using interleavers 32 and 33 shown in Fig. 5(a) will be described below. Since the configurations are the same as those described above except for the interleavers, the same reference numerals as in first and second embodiments denote the same parts in third embodiment, and a description thereof will be omitted.

The interleavers according to the third embodiment performs the following four processes.

1) Information bit sequences are stored in an input buffers the number of which is M (prime number): "17" $\times$ "N: [{(Ti $\times$ S$_{turbo}$) -6}/2] /17" . Reference symbol M denotes an abscissa, reference symbol denotes an ordinate, reference symbol Ti denotes the number of used tones, and S$_{turbo}$ denotes the number of DMT symbols. Reference numeral '6' in the equation expressing the N denotes the number of bits for a terminal process.

2) A specific 16-bit random sequence generated by using a prime number is shifted column by column in units of rows to generate 16 types of random sequences. Zero is mapped on the 17th bits of all the random sequences, mapping patterns from the 17th row to the Nth row are equal to the mapping patterns of the first and subsequent rows, and mapping patterns the number of which is given by "17" $\times$ "[{(Ti $\times$ S$_{turbo}$)-6}/2]/17" are generated.

3) Information bit sequences each having an interleaver length are mapped on the mapping patterns which are generated as described above and the number of which is given by "17" $\times$ "[{(Ti $\times$ S$_{turbo}$)-6}/2]/17".
4) The mapped information bit sequences are read in units of columns and output to the respective recursive systematic convolutional encoders.

The operations of the above processes will be described below. The reason why the number of bits of the abscissa is given by M = 17, i.e., the reason why a mapping pattern has 17 bits will be described below. For example, in a recursive systematic convolutional encoder, self-terminated patterns are generated at specific intervals depending on the number of delay units (generally called memories) . More specifically, when two information bit sequences are used, the self-terminated patterns (input patterns each having an output which is infinitely 0) are generated at intervals of 2$^m$-1 at the most. Reference symbol m denotes the number of memories.

For example, when the recursive systematic convolutional encoder shown in Fig. 5(b) is used, an information bit sequence: u1 is given by {1 (the first bit), 0, 0, 0, 0, 0, 0, 0, 0, 0, 0, 0, 0, 0, 0, 1 (the 16th bit), ..., (it is assumed that the subsequent bits are 0)}, and when all the bits of an information bit sequence: u2 are 0, a self-terminated pattern is generated, and 0 is infinitely output at the 17th and subsequent bits. As a result, demodulation characteristics on the reception side are degraded.

In the third embodiment, bits are rearranged such that a self-terminated pattern must be avoided in any one of the first recursive systematic convolutional encoder 31 and the second recursive systematic convolutional encoder 34.

In order to avoid the self-terminated pattern in any one of the encoders, the abscissa of an input buffer must satisfy M ≥ 2$^m$ + 1, and both rows (M) and columns (N) must have random patterns, respectively. In addition, since M must be a prime number to generate a random pattern using Equation (1), in the third embodiment, the abscissa M of the input buffer, i.e., the number of bits of the mapping pattern is a value which satisfies "M ≥ 2$^m$ + 1 and M = prime number". In a general interleaver, in order to read the information bit sequence subjected to rearrangement by the random pattern in units of columns, a self-terminated pattern must be also avoided on the ordinate. For this reason, the ordinate is given by "N= [{(Ti$\times$S$_{turbo}$)-6}/2]/M". Therefore, when the recursive systematic convolutional encoder having the four delay units as shown in Fig. 5(b), M = 17 and N = [{Ti $\times$ S$_{turbo}$)-6}/2]/17 are satisfied.

In the interleavers 32 and 33, information bit sequences are stored in input buffers the number of which is given by "17" $\times$ "[{Ti $\times$ S$_{turbo}$)-6}/2]/17. At this time, since the two input bit sequences are input to the turbo encoder according to the third embodiment, for example, at least one of rows is rearranged to prevent the inter-signal point distance of the two information bit sequences from being 0.

In the interleavers 32 and 33, a specific 16-bit random sequence generated by a prime number is generated. More specifically, for example, M = P = 17 and a primitive root: go = 3 are satisfied, and a random pattern (random sequence) C is formed by using the Equation (1) described above. As a result, the random pattern C is given by {1, 3, 9, 10, 13, 5, 15, 11, 16, 14, 8, 7, 4, 12, 2, 6,}.

The random pattern is sequentially shifted (left) bit by bit in units of rows to generate random sequences of 16 types. More specifically, a Latin square pattern (16 $\times$ 16) is formed, so that all the rows and columns constitute random sequences. Zero is mapped on the 17th bits of the random sequences of 16 types to generate 17 (M) $\times$ 16 mapping patterns. In addition, the mapping patterns from the 17th row to the Nth row are equal to the mapping patterns of the first and subsequent rows, so that mapping patterns the number of which is given by "17" $\times$ "[{(Ti x S$_{turbo}$)-6}/2]/17" are generated. For this reason, in comparison with the prior art in which an equation is complicated to generate a pseudo random pattern, interleavers can be realized with simple configurations.

In the interleavers 32 and 33, information bit sequences each having an interleaver length are mapped on the mapping patterns the number of which is given by "17" $\times$ "[{(Ti $\times$ S$_{turbo}$)-6}/2]/17" and which are generated as described above. More specifically, by using the mapping patterns the number of which is given by "17" $\times$ "[{(Ti $\times$ S$_{turbo}$)-6}/2]/17", the information bit sequences in the input buffers are rearranged in units of rows.

Finally, in the interleavers 32 and 33, the mapped information bit sequences are read in units of columns and output to the respective recursive systematic convolutional encoders.

As described above, in the third embodiment, the turbo encoder comprising the interleavers which store the information bit sequences in input buffers the number of which is given by "M ≥ 2$^m$ + 1 and M = prime number" $\times$ "N = [{Ti $\times$ S$_{turbo}$)-6}/2]/M", shift a specific (M-1)-bit random sequence generated by a prime number bit by bit in units of rows to generate random sequences (M-1) types, and maps the information bit sequences on M $\times$ N mapping patterns generated from the random sequences of (M-1) types. In addition, a self-terminated pattern can be avoided by any one of the first recursive systematic convolutional encoder 31 and the second recursive systematic convolutional encoder 34. For this reason, error correction capability can be considerably improved. Therefore, since demodulation characteristics on the reception side can be more considerably improved, optimum transmission characteristics which are close to the Shannon limit, i.e., optimum BER characteristics can be obtained.

Fourth Embodiment:

In the fourth embodiment, for example, an operation of a communication apparatus according to the present invention when the recursive systematic convolutional encoder according to first or second embodiment described above and the interleavers according to third embodiment are employed will be described below. Since the configurations of the turbo encoder and the interleaver are the same as those in the embodiments described above, the same reference numerals as in the previous embodiments above denote the same parts in the fourth embodiment, and a description thereof will be omitted.

For example, when data communication by a DMT modulation/demodulation scheme is performed by using a known transmission path such as a telephone line or the like, on the transmission side, a tone ordering process, i. e., a process (a transmission rate is determined by this process) of assigning transmission data each having bits the number of which can be transmitted to a plurality of tones (multi-carrier) in a preset frequency band on the basis of an S/N (signal-to-noise ratio) ratio is performed.

More specifically, for example, as shown in Fig. 22(a), transmission data each having bits the number of which is dependent on an S/N ratio are assigned to tone 0 to tone 9 of respective frequencies. In this case, 0-bit transmission data is assigned to tone 9, 1-bit transmission data are assigned to tone 0, tone 1, tone 7, and tone 8, 2-bit transmission data is assigned to tone 6, 3-bit transmission data is assigned to tone 2, 4-bit transmission data is assigned to tone 5, 5-bit transmission data is assigned to tone 3, and 6-bit transmission data is assigned to tone 4. The 24 bits (information bits: 16 bits and redundant bits: 8 bits) form one frame. The number of bits assigned to the tones is larger than the number of bits of the data frame buffer because redundant bits which are required for error correction are added.

In this manner, one frame of the transmission data subjected to the tone ordering process is constituted as shown in, e.g., Fig. 22(b). More specifically, the tones are arranged in the descending order of the numbers of assignedbits, i.e., tone 9 (b0'), tone 0 (b1'), tone 1 (b2'), tone 7 (b3'), tone 8 (b4'), tone 6 (b5'), tone 2 (b6'), tone 5 (b7'), tone 3 (b8'), and tone 4 (b9'). Tone 9, tone 0, tone 1, and tone 7 are constituted by one tone set, tone 8, tone 6, tone 2, and tone 5 are constituted by one tone set, and tone 3 and tone 4 are constituted by one tone set. For this reason, in the fourth embodiment, the tone sets are formed by two or four tones in the descending order of the numbers of bits assigned by the tone ordering process. The turbo codes each constituted at least 3 bits (3 bits are used when one information bit sequence is used) are assigned to the tone sets. For this reason, transmission data can also be assigned with respect to a tone in which the number of bits which can be transmitted by the tone ordering process is set to be 1.

When a frame processed as shown in Fig. 22 is encoded in units of tone set, data d0 and dummy data d_dummy (because one information bit sequence is used) of the first tone set (tone 9, tone 0, tone 1, and tone 7) are input to terminals u1 and u2 of the turbo encoder 1, a turbo code having two information bits (u1 and u2) and two redundant bits (ua and ub), i.e., 4 bits is output. The two added bits correspond to redundant bits. Since the information bit u2 is dummy data, 3 bits, i.e., u1, ua, and ub are actually encoded.

When data d1 and dummy data d_dummy of the second tone set (tone 8 and tone 6) are input to the terminals u1 and u2 of the turbo encoder, ta turbo code having 4 bits, i.e., two information bits (u1 and u2) and two redundant bits (ua and ub) is output. The two added bits correspond to redundant bits. Since the information bit u2 is dummy data, as in the above description, 3 bits, i.e., u1, ua, and ub are actually encoded.

When data d2, d3, d4, d5, and d6 of the third tone set (tone 2 and tone 5) are input to the terminals u1 and u2 and terminals u4 and u5 of the turbo encoder 1, a turbo code having 4 bits, i.e., two information bits (u1 and u2) and two redundant bits (ua and ub) and the other 3-bit data (u3, u4, ...) are output. The two added bits correspond to redundant bits.

Finally, when data d7, d0, d1, d2, d3, d4, d5, d6, and d7 of the fourth tone set (tone 3 and tone 4) are input to the terminals u1 and u2 and the terminals u4, u5, ... of the turbo encoder 1, a turbo code having 4 bits, i.e., two information bits (u1 and u2) and two redundant bits (ua and ub) and the other 7-bit data (u3, u4,...) are output. The two added bits correspond to redundant bits.

As described above, the tone ordering process and the encoding process are performed on the basis of the S/N ratios, so that transmission data are multiplexed every frame. In addition, on the transmission side, fast Fourier transform (IFFT) is performed to the multiplexed transmission data. Thereafter, a digital waveform is converted into an analog waveform through a D/A converter. Finally, the analog data passes through a low-pass filter, and the final transmission data is transmitted onto a telephone line.

In this manner, in the fourth embodiment, a tone set is formed by two or four tines in the descending order of the numbers of bits assigned by the tone ordering process, and a turbo code constituted by at least three bits is assigned to the tone set. For this reason, unlike the prior art, transmission data can also be assigned with respect to a tone in which the number of bits which can be transmitted by the tone ordering process is set to be 1. For this reason, in the communication apparatus according to the fourth embodiment, transmission efficiency can be considerably improved in comparison with the prior art.

As has been described above, according to one aspect of the present invention, when a recursive systematic convolutional encoder having a constraint length: 5 and the number of memories: 4 is supposed as an example, an optimum recursive systematic convolutional encoder is determined such that a block length L, an input weight 2, an interval de between bits '1' of a self-terminated pattern is maximum, and a total weight is maximum in the pattern in which the interval de is maximum. This recursive systematic convolutional encoder is employed as a turbo encoder. For this reason, a communication apparatus which can considerably improve BER characteristics on the reception side can be obtained advantageously.

According to another aspect of the present invention, when a recursive systematic convolutional encoder having a constraint length: 4 and the number of memories: 3 is supposed as an example, an optimum recursive systematic convolutional encoder is determined such that a block length L, an input weight 2, an interval de between bits '1' of a self-terminated pattern is maximum, and a total weight is maximum in the pattern in which the interval de is maximum. This recursive systematic convolutional encoder is employed as a turbo encoder. For this reason, BER characteristics on the reception side can be considerably improved in comparison with a conventional communication apparatus, and a circuit scale can be considerably reduced. Therefore, a communication apparatus which can realize an inexpensive communication apparatus can be obtained advantageously.

Moreover, a turbo encoder comprising interleavers which store the information bit sequences in input buffers the number of which is given by "$M \geq 2^m + 1$ and M = prime number" $\times$ "N = [{Ti $\times$ S$_{turbo}$}-6}/2]/M", shift a specific (M-1)-bit random sequence generated by a prime number bit by bit in units of rows to generate random sequences (M-1) types, and maps the information bit sequences on M $\times$ N mapping patterns generated from the random sequences of (M-1) types. In addition, a self-terminated pattern can be avoided by any one of the first recursive systematic convolutional encoder and the second recursive systematic convolutional encoder. For this reason, since demodulation characteristics on the reception side can be more considerably improved, a communication apparatus which can obtain optimum transmission characteristics which are close to the Shannon limit, i.e., optimum BER characteristics can be obtained advantageously.

Furthermore, a tone set is formed by two or four tines in the descending order of the numbers of bits assigned by the tone ordering process, and a turbo code constituted by at least three bits is assigned to the tone set. For this reason, unlike a conventional communication apparatus, transmission data can also be assigned with respect to a tone in which the number of bits which can be transmitted by the tone ordering process is set to be 1. For this reason, a communication apparatus which can considerably improve transmission efficiency can be obtained advantageously.

According to still another aspect of the present invention, an optimum recursive systematic convolutional encoder is determined such that a block length L, an input weight 2, an interval de between bits '1' of a self-terminated pattern is maximum, and a total weight in the pattern in which the interval de is maximum is maximum. For this reason, a communication method which can considerably improve BER characteristics on the reception side can be obtained advantageously.

Moreover, information bit sequences are stored in input buffers the number of which is given by "$M \geq 2^m + 1$ and M = prime number" $\times$ "N = [{Ti $\times$ S$_{turbo}$) -6}/2] /M", a specific (M-1)-bit random sequence generated by a prime number is shifted bit by bit in units of rows to generate random sequences (M-1) types, and the information bit sequences are mapped on M x N mapping patterns generated from the random sequences of (M-1) types. For this reason, the information bits can be rearranged, and a self-terminated pattern can be necessarily avoided by any one of the first recursive systematic convolutional encoder and the second recursive systematic convolutional encoder. For this reason, a communication method which can more considerably improve demodulation characteristics on the reception side can be obtained advantageously.

Furthermore, a tone set is formed by two or four tines in the descending order of the numbers of bits assigned by the tone ordering process, and a turbo code constituted by at least three bits is assigned to the tone set. For this reason, unlike a conventional communication method, transmission data can also be assigned with respect to a tone in which the number of bits which can be transmitted by the tone ordering process is set to be 1. For this reason, a communication method which can considerably improve transmission efficiency can be obtained advantageously.

INDUSTRIAL APPLICABILITY

As has been described above, a communication apparatus and a communication method according to the present invention are applied to a communication apparatus for performing data communication by a DMT modulation/demodulation scheme or all communications using a multi-carrier modulation/demodulation scheme and a single-carrier modulation/demodulation scheme.

**Claims**

**1.** A communication apparatus comprising a turbo encoder which includes

a first recursive systematic convolutional encoder for convolutionally encoding two information bit sequences to output first redundant data; and
a second recursive systematic convolutional encoder for convolutionally encoding the information bit sequences subjected to an interleave process to output second redundant data,

wherein each of said first and second recursive systematic convolutional encoders searches all connection patterns constituting said encoders when a recursive systematic convolutional encoder is assumed to have a constraint length of "5" and the number of memories of "4", and satisfies optimum conditions that an interval between two bits '1' of a self-terminated pattern is maximum in a specific block length and that a total weight in the pattern having the maximum interval is maximum in the specific block length.

2. The communication apparatus according to claim 1, wherein said turbo encoder further comprises an interleaver, wherein said interleaver, when M is a prime number representing a value on an abscissa, N is a natural number representing a value on an ordinate, m is an integer, Ti is a number of tones, $S_{turbo}$ is a number of DMT symbols, and Tail is a number of bits for a terminating process,
stores the information bit sequences in input buffers the number of which is given by M $\geq 2^m + 1$" $\times$ "N = [{Ti $\times S_{turbo}$)-Tail}/2]/M;
shifts a random sequence of specific (M-1) bits generated by the prime number bit by bit in units of rows to generate random sequences of (M-1) types, maps minimum values on Mth bits of the respective rows in all the random sequences, makes mapping patterns of the Mth and subsequent rows equal to the mapping patterns of the first and subsequent rows to generate an M x N mapping pattern;
maps information bit sequences each having an interleaving length on the M $\times$ N mapping pattern; and
reads the information bit sequences subjected to mapping in units of columns to output the information bit sequences to said second recursive systematic convolutional encoder.

3. The communication apparatus according to claim 1, wherein a tone set is formed by two or four tones in the descending order of the number of bits assigned in a tone ordering process, and at least a three-bit turbo code constituted by the two information bits or one of the two information bits and the first and second redundant bits is assigned to the tone set.

4. A communication apparatus comprising a turbo encoder which includes
a first recursive systematic convolutional encoder for convolutionally encoding two information bit sequences to output first redundant data; and
a second recursive systematic convolutional encoder for convolutionally encoding the information bit sequences subjected to an interleave process to output second redundant data,
wherein each of said first and second recursive systematic convolutional encoders searches all connection patterns constituting said encoders when a recursive systematic convolutional encoder is assumed to have a constraint length of "4" and the number of memories of "3", and satisfies optimum conditions that an interval between two bits '1' of a self-terminated pattern is maximum in a specific block length and that a total weight in the pattern having the maximum interval is maximum in the specific block length.

5. The communication apparatus according to claim 4, wherein said turbo encoder further comprises an interleaver, wherein said interleaver, when M is a prime number representing a value on an abscissa, N is a natural number representing a value on an ordinate, m is an integer, Ti is a number of tones, $S_{turbo}$ is a number of DMT symbols, and Tail is a number of bits for a terminating process,
stores the information bit sequences in input buffers the number of which is given by M $\geq 2^m + 1$" x "N = [{Ti $\times S_{turbo}$)-Tail}/2]/M;
shifts a random sequence of specific (M-1) bits generated by the prime number bit by bit in units of rows to generate random sequences of (M-1) types, maps minimum values on Mth bits of the respective rows in all the random sequences, makes mapping patterns of the Mth and subsequent rows equal to the mapping patterns of the first and subsequent rows to generate an M $\times$ N mapping pattern;
maps information bit sequences each having an interleaving length on the M $\times$ N mapping pattern; and
reads the information bit sequences subjected to mapping in units of columns to output the information bit sequences to said second recursive systematic convolutional encoder.

6. The communication apparatus according to claim 4, wherein a tone set is formed by two or four tones in the descending order of the number of bits assigned in a tone ordering process, and at least a three-bit turbo code constituted by the two information bits or one of the two information bits and the first and second redundant bits is assigned to the tone set.

7. A communication method comprising:

   a turbo encoding step of convolutionally encoding two information bit sequences to output first redundant data together with the two information bit sequences and convolutionally encoding the information bit sequences subjected to an interleave process to output second redundant data,
   the turbo encoding step is executed by using a recursive systematic convolutional encoder which satisfies optimum conditions that an interval between two bits '1' of a self-terminated pattern is maximum in a specific block length and that a total weight in the pattern having the maximum interval is maximum in the specific block length.

8. The communication method according to claim 7, wherein the turbo encoding step includes, when M is a prime number representing a value on an abscissa, N is a natural number representing a value on an ordinate, m is an integer, Ti is a number of tones, $S_{turbo}$ is a number of DMT symbols, and Tail is a number of bits for a terminating process,
   storing the information bit sequences in input buffers the number of which is given by $M \geq 2^m + 1$" $\times$ "N = [{Ti x $S_{turbo}$)-Tail}/2]/M;
   shifting a random sequence of specific (M-1) bits generated by the prime number bit by bit in units of rows to generate random sequences of (M-1) types, mapping minimum values on Mth bits of the respective rows in all the random sequences, and generating mapping patterns of the Mth and subsequent rows equal to the mapping patterns of the first and subsequent rows to generate an $M \times N$ mapping pattern;
   mapping information bit sequences each having an interleaving length on the $M \times N$ mapping pattern; and
   reading the information bit sequences subjected to the mapping in units of columns.

9. The communication method according to claim 7, wherein a tone set is formed by two or four tones in the descending order of the number of bits assigned in a tone ordering process, and at least a three-bit turbo code constituted by the two information bits or one of the two information bits and the first and second redundant bits is assigned to the tone set.

# FIG.1

(a)

(b)

EP 1 294 102 A1

# FIG.2

# FIG.3

# FIG.4

(a)

(b)

(c)

# FIG.5

(a)

(b)

EP 1 294 102 A1

## FIG.6

# FIG.7

# FIG.8

# FIG.9

# FIG.10

====generation polynominal=[10011,11101,10001]

| u2 | u1 | u0 | state |
|----|----|----|-------|
| 0 | 1 | 1 | 0111 |
| 0 | 0 | 1 | 1010 |
| 0 | 0 | 0 | 0101 |
| 0 | 0 | 1 | 1011 |
| 0 | 0 | 1 | 1100 |
| 0 | 0 | 0 | 0110 |
| 0 | 0 | 0 | 0011 |
| 0 | 0 | 1 | 1000 |
| 0 | 0 | 0 | 0100 |
| 0 | 0 | 0 | 0010 |
| 1 | 0 | 1 | 0000 |
| 0 | 0 | 0 | 0000 |
| 0 | 0 | 0 | 0000 |
| 0 | 0 | 0 | 0000 |
| 0 | 0 | 0 | 0000 |
| 0 | 0 | 0 | 0000 |

information weight=2 weight total=8

# FIG.11

====generation polynominal=[11001,10001,10111]

| u2 | u1 | u0 | state |
|----|----|----|-------|
| 0 | 1 | 1 | 0100 |
| 0 | 0 | 0 | 0010 |
| 0 | 0 | 0 | 0001 |
| 0 | 0 | 1 | 1100 |
| 0 | 0 | 0 | 0110 |
| 0 | 0 | 0 | 0011 |
| 0 | 0 | 1 | 1101 |
| 0 | 0 | 1 | 1010 |
| 0 | 0 | 0 | 0101 |
| 0 | 0 | 1 | 1110 |
| 1 | 0 | 1 | 0000 |
| 0 | 0 | 0 | 0000 |
| 0 | 0 | 0 | 0000 |
| 0 | 0 | 0 | 0000 |
| 0 | 0 | 0 | 0000 |
| 0 | 0 | 0 | 0000 |

information weight=2 weight total=8

FIG.12

## FIG.13

## FIG.14

# FIG.15

# FIG.16

# FIG.17

u₂

u₁

61    62    63

65    66    67    68  uₐ or u_b

# FIG.18

====generation polynominal=[1011,1101,0101]

| u2 | u1 | u0 | state |
|----|----|----|-------|
| 0 | 1 | 1 | 011 |
| 0 | 0 | 1 | 100 |
| 0 | 0 | 0 | 010 |
| 0 | 0 | 0 | 001 |
| 0 | 0 | 1 | 101 |
| 1 | 0 | 0 | 000 |
| 0 | 0 | 0 | . |
| 0 | 0 | 0 | . |
| . | . | . | . |
| . | . | . | . |
| . | . | . | . |

information weight=2    weight total=5

# FIG.19

====generation polynominal=[1011,1110,1001]

| u2 | u1 | u0 | state |
|----|----|----|-------|
| 0  | 1  | 0  | 111   |
| 0  | 0  | 1  | 110   |
| 0  | 0  | 0  | 011   |
| 0  | 0  | 1  | 100   |
| 0  | 0  | 0  | 010   |
| 1  | 0  | 1  | 000   |
| 0  | 0  | 0  | .     |
| 0  | 0  | 0  | .     |
| .  | .  | .  | .     |
| .  | .  | .  | .     |
| .  | .  | .  | .     |

information weight=2    weight total=5

# FIG.20

====generation polynominal=[1101,1001,0111]

| u2 | u1 | u0 | state |
|----|----|----|-------|
| 0 | 1 | 1 | 010 |
| 0 | 0 | 0 | 001 |
| 0 | 0 | 1 | 110 |
| 0 | 0 | 0 | 011 |
| 0 | 0 | 1 | 111 |
| 1 | 0 | 0 | 000 |
| 0 | 0 | 0 | . |
| 0 | 0 | 0 | . |
| . | . | . | . |
| . | . | . | . |
| . | . | . | . |

information weight=2    weight total=5

# FIG.21

====generation polynominal=[1101,1010,1011]

| u2 | u1 | u0 | state |
|----|----|----|-------|
| 0  | 1  | 0  | 101   |
| 0  | 0  | 1  | 100   |
| 0  | 0  | 0  | 010   |
| 0  | 0  | 0  | 001   |
| 0  | 0  | 1  | 110   |
| 1  | 0  | 1  | 000   |
| 0  | 0  | 0  | .     |
| 0  | 0  | 0  | .     |
| .  | .  | .  | .     |
| .  | .  | .  | .     |
| .  | .  | .  | .     |
| .  | .  | .  | .     |

information weight=2    weight total=5

# FIG.22

(a)

TONE ORDERED
$b_0'=b_9=0$
$b_1'=b_0=1$
$b_2'=b_1=1$
$b_3'=b_7=1$
$b_4'=b_8=1$
$b_5'=b_6=2$
$b_6'=b_2=3$
$b_7'=b_5=4$
$b_8'=b_3=5$
$b_9'=b_4=6$

(b)

EP 1 294 102 A1

# FIG.23

(a)

(b)

# FIG.24

EP 1 294 102 A1

# FIG.25

| N\M | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 1 | 19 | 43 | 22 | 47 | 45 | 7 | 27 | 36 | 48 | 11 | 50 | 49 | 30 | 40 | 18 | 24 | 32 | 25 | 51 |
| 2 | 1 | 21 | 17 | 39 | 24 | 27 | 37 | 35 | 46 | 12 | 40 | 45 | 44 | 23 | 6 | 20 | 49 | 22 | 38 | 3 |
| 3 | 1 | 45 | 11 | 18 | 15 | 39 | 6 | 5 | 13 | 2 | 37 | 22 | 36 | 30 | 25 | 12 | 10 | 26 | 4 | 21 |
| 4 | 1 | 33 | 29 | 3 | 46 | 34 | 9 | 32 | 49 | 27 | 43 | 41 | 28 | 23 | 17 | 31 | 16 | 51 | 40 | 48 |
| 5 | 1 | 12 | 38 | 32 | 13 | 50 | 17 | 45 | 10 | 14 | 9 | 2 | 24 | 23 | 11 | 26 | 47 | 34 | 37 | 20 |
| 6 | 1 | 3 | 9 | 27 | 28 | 31 | 40 | 14 | 42 | 20 | 7 | 21 | 10 | 30 | 37 | 5 | 15 | 45 | 29 | 34 |
| 7 | 1 | 30 | 52 | 23 | 1 | 30 | 52 | 23 | 1 | 30 | 52 | 23 | 1 | 30 | 52 | 23 | 1 | 30 | 52 | 23 |
| 8 | 1 | 34 | 43 | 31 | 47 | 8 | 7 | 26 | 36 | 5 | 11 | 3 | 49 | 23 | 40 | 35 | 24 | 21 | 25 | 2 |
| 9 | 1 | 22 | 7 | 48 | 49 | 18 | 25 | 20 | 16 | 34 | 6 | 26 | 42 | 23 | 29 | 2 | 44 | 14 | 43 | 45 |
| 10 | 1 | 2 | 4 | 8 | 16 | 32 | 11 | 22 | 44 | 35 | 17 | 34 | 15 | 30 | 7 | 14 | 28 | 3 | 6 | 12 |

| N\M | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 15 | 20 | 9 | 12 | 16 | 39 | 52 | 34 | 10 | 31 | 6 | 8 | 46 | 26 | 17 | 5 | 42 | 3 | 4 | 23 |
| 2 | 10 | 51 | 11 | 19 | 28 | 5 | 52 | 32 | 36 | 14 | 29 | 26 | 16 | 18 | 7 | 41 | 13 | 8 | 9 | 30 |
| 3 | 44 | 19 | 7 | 50 | 24 | 20 | 32 | 8 | 42 | 35 | 38 | 14 | 47 | 48 | 40 | 51 | 16 | 31 | 17 | 23 |
| 4 | 47 | 14 | 38 | 35 | 42 | 8 | 52 | 20 | 24 | 50 | 7 | 19 | 44 | 21 | 4 | 26 | 10 | 12 | 25 | 30 |
| 5 | 28 | 18 | 4 | 48 | 46 | 22 | 52 | 41 | 15 | 21 | 40 | 3 | 36 | 8 | 43 | 39 | 44 | 51 | 29 | 30 |
| 6 | 49 | 41 | 17 | 51 | 47 | 35 | 52 | 50 | 44 | 26 | 25 | 22 | 13 | 39 | 11 | 33 | 46 | 32 | 43 | 23 |
| 7 | 1 | 30 | 52 | 23 | 1 | 30 | 52 | 23 | 1 | 30 | 52 | 23 | 1 | 30 | 52 | 23 | 1 | 30 | 52 | 23 |
| 8 | 15 | 33 | 9 | 41 | 16 | 14 | 52 | 19 | 10 | 22 | 6 | 45 | 46 | 27 | 17 | 48 | 42 | 50 | 4 | 30 |
| 9 | 36 | 50 | 40 | 32 | 15 | 12 | 52 | 31 | 46 | 5 | 4 | 35 | 28 | 33 | 37 | 19 | 47 | 27 | 11 | 30 |
| 10 | 24 | 48 | 43 | 33 | 13 | 26 | 52 | 51 | 49 | 45 | 37 | 21 | 42 | 31 | 9 | 18 | 36 | 19 | 38 | 23 |

| N\M | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 13 | 35 | 29 | 21 | 28 | 2 | 38 | 33 | 44 | 41 | 37 | 14 | 0 |
| 2 | 47 | 33 | 4 | 31 | 15 | 50 | 43 | 2 | 42 | 34 | 25 | 48 | 0 |
| 3 | 28 | 41 | 43 | 27 | 49 | 32 | 9 | 34 | 46 | 3 | 29 | 33 | 0 |
| 4 | 36 | 22 | 37 | 2 | 13 | 5 | 6 | 39 | 15 | 18 | 11 | 45 | 0 |
| 5 | 42 | 27 | 6 | 19 | 16 | 33 | 25 | 35 | 49 | 5 | 7 | 31 | 0 |
| 6 | 16 | 48 | 38 | 8 | 24 | 19 | 4 | 12 | 36 | 2 | 6 | 18 | 0 |
| 7 | 1 | 30 | 52 | 23 | 1 | 30 | 52 | 23 | 1 | 30 | 52 | 23 | 0 |
| 8 | 13 | 18 | 29 | 32 | 28 | 51 | 38 | 20 | 44 | 12 | 37 | 39 | 0 |
| 9 | 24 | 51 | 9 | 39 | 10 | 8 | 17 | 3 | 13 | 21 | 38 | 41 | 0 |
| 10 | 45 | 39 | 25 | 50 | 47 | 41 | 29 | 5 | 10 | 20 | 40 | 27 | 0 |

EP 1 294 102 A1

# FIG.26

| N\M | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 1 | 19 | 43 | 22 | 47 | 45 | 7 | 27 | 36 | 48 | 11 | 50 | 49 | 30 | 40 | 18 | 24 | 32 | 25 | 51 |
| 2 | 54 | 74 | 70 | 92 | 77 | 80 | 90 | 88 | 99 | 65 | 93 | 98 | 97 | 76 | 59 | 73 | 102 | 75 | 91 | 56 |
| 3 | 107 | 151 | 117 | 124 | 121 | 145 | 112 | 111 | 119 | 108 | 143 | 128 | 142 | 136 | 131 | 118 | 116 | 132 | 110 | 127 |
| 4 | 160 | 192 | 188 | 162 | 205 | 193 | 168 | 191 | 208 | 186 | 202 | 200 | 187 | 182 | 176 | 190 | 175 | 210 | 199 | 207 |
| 5 | 213 | 224 | 250 | 244 | 225 | 262 | 229 | 257 | 222 | 226 | 221 | 214 | 236 | 235 | 223 | 238 | 259 | 246 | 249 | 232 |
| 6 | 266 | 268 | 274 | 292 | 293 | 296 | 305 | 279 | 307 | 285 | 272 | 286 | 275 | 295 | 302 | 270 | 280 | 310 | 294 | 299 |
| 7 | 319 | 348 | 370 | 341 | 319 | 348 | 370 | 341 | 319 | 348 | 370 | 341 | 319 | 348 | 370 | 341 | 319 | 388 | 370 | 341 |
| 8 | 372 | 405 | 414 | 402 | 418 | 379 | 378 | 397 | 407 | 376 | 382 | 374 | 420 | 394 | 411 | 406 | 395 | 392 | 396 | 373 |
| 9 | 425 | 446 | 431 | 472 | 473 | 442 | 449 | 444 | 440 | 458 | 430 | 450 | 466 | 447 | 453 | 426 | 468 | 430 | 467 | 469 |
| 10 | 478 | 479 | 481 | 485 | 493 | 509 | 488 | 499 | 521 | 512 | 494 | 511 | 492 | 507 | 484 | 491 | 505 | 480 | 483 | 489 |

| N\M | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 15 | 20 | 9 | 12 | 16 | 39 | 52 | 34 | 10 | 31 | 6 | 8 | 46 | 26 | 17 | 5 | 42 | 3 | 4 | 23 |
| 2 | 63 | 104 | 64 | 72 | 81 | 58 | 105 | 85 | 89 | 67 | 82 | 79 | 69 | 71 | 60 | 94 | 66 | 61 | 62 | 83 |
| 3 | 150 | 125 | 113 | 156 | 130 | 126 | 158 | 114 | 148 | 141 | 144 | 120 | 153 | 154 | 146 | 157 | 122 | 137 | 123 | 129 |
| 4 | 206 | 173 | 197 | 194 | 201 | 167 | 211 | 179 | 183 | 209 | 166 | 178 | 203 | 180 | 163 | 185 | 169 | 171 | 184 | 189 |
| 5 | 240 | 230 | 216 | 260 | 258 | 234 | 264 | 253 | 227 | 233 | 252 | 215 | 246 | 220 | 255 | 251 | 256 | 263 | 241 | 242 |
| 6 | 314 | 306 | 282 | 316 | 312 | 300 | 319 | 315 | 309 | 291 | 290 | 287 | 218 | 304 | 276 | 298 | 311 | 297 | 308 | 288 |
| 7 | 319 | 348 | 370 | 341 | 319 | 348 | 370 | 341 | 319 | 348 | 370 | 341 | 319 | 348 | 370 | 341 | 319 | 348 | 370 | 341 |
| 8 | 386 | 404 | 380 | 412 | 387 | 385 | 423 | 390 | 381 | 393 | 377 | 416 | 417 | 398 | 388 | 419 | 413 | 421 | 375 | 401 |
| 9 | 460 | 474 | 464 | 456 | 439 | 436 | 476 | 455 | 470 | 429 | 428 | 459 | 452 | 457 | 461 | 443 | 471 | 451 | 435 | 454 |
| 10 | 501 | 525 | 520 | 510 | 490 | 503 | 529 | 528 | 526 | 522 | 514 | 498 | 519 | 508 | 486 | 495 | 543 | 496 | 515 | 500 |

| N\M | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 13 | 35 | 29 | 21 | 28 | 2 | 38 | 33 | 44 | 41 | 37 | 14 | 0 |
| 2 | 100 | 86 | 57 | 84 | 68 | 103 | 96 | 55 | 95 | 87 | 78 | 101 | 53 |
| 3 | 134 | 147 | 149 | 133 | 155 | 138 | 115 | 140 | 152 | 109 | 135 | 139 | 106 |
| 4 | 195 | 181 | 196 | 161 | 172 | 164 | 165 | 198 | 174 | 177 | 170 | 204 | 159 |
| 5 | 254 | 239 | 218 | 231 | 228 | 245 | 237 | 247 | 261 | 217 | 219 | 243 | 212 |
| 6 | 281 | 313 | 303 | 273 | 289 | 284 | 269 | 277 | 301 | 267 | 271 | 283 | 265 |
| 7 | 319 | 348 | 370 | 341 | 319 | 348 | 370 | 341 | 319 | 348 | 370 | 341 | 318 |
| 8 | 384 | 389 | 400 | 403 | 399 | 422 | 409 | 391 | 415 | 383 | 408 | 410 | 371 |
| 9 | 448 | 475 | 433 | 463 | 434 | 432 | 441 | 427 | 437 | 445 | 462 | 465 | 424 |
| 10 | 523 | 516 | 502 | 527 | 524 | 518 | 506 | 482 | 487 | 497 | 517 | 504 | 477 |

EP 1 294 102 A1

## FIG.27

| M\N | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 478 | 479 | 481 | 485 | 493 | 509 | 488 | 499 | 521 | 512 | 494 | 511 | 492 | 507 | 484 | 491 | 505 | 480 | 483 | 489 |
| 2 | 425 | 446 | 431 | 472 | 473 | 442 | 449 | 444 | 440 | 458 | 430 | 450 | 466 | 447 | 453 | 426 | 468 | 438 | 467 | 469 |
| 3 | 372 | 405 | 414 | 402 | 418 | 379 | 378 | 397 | 407 | 376 | 382 | 374 | 420 | 394 | 411 | 406 | 395 | 392 | 396 | 373 |
| 4 | 319 | 348 | 370 | 341 | 319 | 348 | 370 | 341 | 319 | 348 | 370 | 341 | 319 | 348 | 370 | 341 | 319 | 348 | 370 | 341 |
| 5 | 266 | 268 | 274 | 292 | 293 | 296 | 305 | 279 | 307 | 285 | 272 | 286 | 275 | 295 | 302 | 270 | 280 | 310 | 294 | 299 |
| 6 | 213 | 224 | 250 | 244 | 225 | 262 | 229 | 257 | 222 | 226 | 221 | 214 | 236 | 235 | 223 | 238 | 259 | 246 | 249 | 232 |
| 7 | 160 | 192 | 188 | 162 | 205 | 193 | 168 | 191 | 208 | 186 | 202 | 200 | 187 | 182 | 176 | 190 | 175 | 210 | 199 | 207 |
| 8 | 107 | 151 | 117 | 124 | 121 | 145 | 112 | 111 | 119 | 108 | 143 | 128 | 142 | 136 | 131 | 118 | 116 | 132 | 110 | 127 |
| 9 | 54 | 74 | 70 | 92 | 77 | 80 | 90 | 88 | 99 | 65 | 93 | 98 | 97 | 76 | 59 | 73 | 102 | 75 | 91 | 56 |
| 10 | 1 | 19 | 43 | 22 | 47 | 45 | 7 | 27 | 36 | 48 | 11 | 50 | 49 | 30 | 40 | 18 | 24 | 32 | 25 | 51 |

| M\N | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 501 | 525 | 520 | 510 | 490 | 503 | 529 | 528 | 526 | 522 | 514 | 498 | 519 | 508 | 486 | 495 | 513 | 496 | 515 | 500 |
| 2 | 460 | 474 | 464 | 456 | 439 | 436 | 476 | 455 | 470 | 429 | 428 | 459 | 452 | 457 | 461 | 443 | 471 | 451 | 435 | 454 |
| 3 | 386 | 404 | 380 | 412 | 387 | 385 | 423 | 390 | 381 | 393 | 377 | 416 | 417 | 398 | 388 | 419 | 413 | 421 | 375 | 401 |
| 4 | 319 | 348 | 370 | 341 | 319 | 348 | 370 | 341 | 319 | 348 | 370 | 341 | 319 | 348 | 370 | 341 | 319 | 348 | 370 | 341 |
| 5 | 314 | 306 | 282 | 316 | 312 | 300 | 317 | 315 | 309 | 291 | 290 | 287 | 278 | 304 | 376 | 298 | 311 | 297 | 308 | 288 |
| 6 | 240 | 230 | 216 | 260 | 258 | 234 | 264 | 253 | 227 | 233 | 252 | 215 | 248 | 220 | 255 | 251 | 256 | 263 | 241 | 242 |
| 7 | 206 | 173 | 197 | 194 | 201 | 167 | 211 | 179 | 183 | 209 | 166 | 178 | 203 | 180 | 163 | 185 | 169 | 171 | 184 | 189 |
| 8 | 150 | 125 | 113 | 156 | 130 | 126 | 158 | 114 | 148 | 141 | 144 | 120 | 153 | 154 | 146 | 157 | 122 | 137 | 123 | 129 |
| 9 | 63 | 104 | 64 | 72 | 81 | 58 | 105 | 85 | 89 | 67 | 82 | 79 | 69 | 71 | 60 | 94 | 66 | 61 | 62 | 83 |
| 10 | 15 | 20 | 9 | 12 | 16 | 39 | 52 | 34 | 10 | 31 | 6 | 8 | 46 | 26 | 17 | 5 | 42 | 3 | 4 | 23 |

| M\N | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 523 | 516 | 502 | 527 | 524 | 518 | 506 | 482 | 487 | 497 | 517 | 504 | 477 |
| 2 | 448 | 475 | 433 | 463 | 434 | 432 | 441 | 427 | 437 | 445 | 462 | 465 | 424 |
| 3 | 384 | 389 | 400 | 403 | 399 | 422 | 409 | 391 | 415 | 383 | 408 | 410 | 371 |
| 4 | 319 | 348 | 370 | 341 | 319 | 348 | 370 | 341 | 319 | 343 | 370 | 341 | 318 |
| 5 | 281 | 313 | 303 | 273 | 289 | 284 | 269 | 277 | 301 | 267 | 271 | 283 | 265 |
| 6 | 254 | 239 | 218 | 231 | 228 | 245 | 237 | 247 | 261 | 217 | 219 | 243 | 212 |
| 7 | 195 | 101 | 196 | 161 | 172 | 164 | 165 | 198 | 174 | 177 | 170 | 204 | 159 |
| 8 | 134 | 147 | 149 | 133 | 155 | 138 | 115 | 140 | 152 | 109 | 135 | 139 | 106 |
| 9 | 100 | 86 | 57 | 84 | 68 | 103 | 96 | 55 | 95 | 87 | 78 | 101 | 53 |
| 10 | 13 | 35 | 29 | 21 | 28 | 2 | 38 | 33 | 44 | 41 | 37 | 14 | 0 |

# FIG.28

# FIG.29

# FIG.30

(a)

TONE ORDERED

$b_0'=b_0=2$
$b_1'=b_5=2$
$b_2'=b_1=3$
$b_3'=b_4=3$
$b_4'=b_2=4$
$b_5'=b_3=5$

(b)

DATA FRAME BUFFER

FAST DATA BUFFER

INTERLEAVED DATA BUFFER

TONE0 2bit  TONE5 2bit  TONE1 3bit  TONE4 3bit  TONE2 4bit  TONE3 5bit

EP 1 294 102 A1

EP 1 294 102 A1

## INTERNATIONAL SEARCH REPORT

| International application No. |
|---|
| PCT/JP01/04642 |

**A. CLASSIFICATION OF SUBJECT MATTER**
Int.Cl⁷ H03M13/23

According to International Patent Classification (IPC) or to both national classification and IPC

**B. FIELDS SEARCHED**

Minimum documentation searched (classification system followed by classification symbols)
Int.Cl⁷ H03M13/00

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 97/25793 A (Nokia Mobile Phones, Ltd.), 17 July, 1997 (17.07.97), abstract & EP 873613 A & JP 2000-503185 A & US 6038695 A | 1-9 |
| P,A | JP 2001-86007 A (Mitsubishi Electric Corporation), 30 March, 2001 (30.03.01), abstract (Family: none) | 1-9 |
| P,A | JP 2001-127649 A (Mitsubishi Electric Corporation), 11 May, 2001 (11.05.01), abstract & WO 01/33719 | 1-9 |
| P,A | JP 2001-186023 A (Mitsubishi Electric Corporation), 06 July, 2001 (06.07.01), abstract (Family: none) | 1-9 |

☐ Further documents are listed in the continuation of Box C.   ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 16 July, 2001 (16.07.01) | 31 July, 2001 (31.07.01) |

| Name and mailing address of the ISA/ Japanese Patent Office | Authorized officer |
|---|---|
| Facsimile No. | Telephone No. |

Form PCT/ISA/210 (second sheet) (July 1992)

46